# DEMANDE DE BREVET EUROPEEN

(11) **EP 4 848 951 A1**
(43) Date de publication de la demande: **02.12.2026**
(21) Numéro de dépôt: 26180142.7
(22) Date de dépôt: 21.05.2026
(51) Int. Cl.: H10H 29/01, H10H 29/14, H10H 29/80, H10H 29/851, H10H 29/856, H10H 20/01

(54) **PROCÉDÉ DE FABRICATION D'UN DISPOSITIF OPTOÉLECTRONIQUE À CONVERTISSEURS DE COULEURS AUTO-ALIGNÉS**

(30) Priorité: 28.05.2025 FR 2505737
(71) Demandeur: Commissariat à l'Energie Atomique et aux Energies Alternatives, 75015 Paris (FR)
(72) Inventeur: ALTAZIN, STEPHANE, 38054 Grenoble cedex 09 (FR); BILDE, JÉRÉMY, 38054 Grenoble cedex 09 (FR); SUHM, AURÉLIEN, 38054 Grenoble cedex 09 (FR); BALLOT, CLÉMENT, 38054 Grenoble cedex 09 (FR)
(74) Mandataire: Hautier IP

(57) **Abrégé**

L'invention concerne un procédé de fabrication d'un dispositif optoélectronique à convertisseurs de couleurs auto-alignés. On fournit un empilement comprenant une couche active (100) et une couche isolante comprenant au moins une première sous-couche isolante. On forme des ouvertures traversant la couche isolante et la couche active, de manière à définir une pluralité de diodes surmontées d'une portion de la première sous-couche isolante. Au niveau de chaque ouverture, on forme une couche de revêtement (300) électriquement isolante contre des flancs internes des diodes puis on forme dans chaque ouverture une couche réflectrice (400). On retire ensuite au moins une des portions de la première sous-couche isolante, formant ainsi au moins une cavité (600) dans laquelle on forme un élément convertisseur (700).

## Description

### DOMAINE TECHNIQUE

La présente invention concerne le domaine des technologies de la microélectronique et de l'optoélectronique, notamment la fabrication de réseaux de diodes émettrices ou réceptrices de lumière telles que des LED (de l'anglais « Light-Emitting Diode », se traduisant en français par diode électroluminescente), et tout particulièrement de micro-LED. Elle s'intéresse tout particulièrement à l'intégration d'éléments convertisseurs de couleurs dans un tel réseau. Elle trouve pour application particulièrement avantageuse mais non limitative les systèmes d'affichage à base de micro-LED.

### ETAT DE LA TECHNIQUE

La réalisation de réseaux de diodes intégrant des convertisseurs de couleurs nécessite la formation de murs réfléchissants entre les convertisseurs. En effet, sans ces murs réfléchissants, on assisterait à un phénomène de diaphonie optique (couramment désigné par le terme anglais de « optical crosstalk ») entre les LEDs qui, en plus de limiter le rendement du réseau, empêcherait le pilotage correct de l'émission lumineuse par couleur.

Il existe dans l'art antérieur plusieurs techniques de fabrication de réseaux de diodes dotés de convertisseurs de couleurs et de murs réfléchissants.

Une première approche notamment décrite dans le document FR3061358 A1 consiste en la formation d'un étage comprenant un ensemble de diodes, puis la formation par photolithographie et gravure de boîtes quantiques permettant la conversion de couleur à l'aplomb des diodes. Un dépôt conforme d'un matériau réfléchissant est ensuite réalisé sur l'ensemble, puis une gravure directive du matériau réfléchissant est effectuée pour mettre à jour la face supérieure des boîtes quantiques. Cette méthode est cependant limitée par les facteurs de forme pouvant être obtenus lors de la réalisation des boîtes quantiques. Par ailleurs, le dépôt du matériau réfléchissant puis son retrait au niveau des faces supérieures des boîtes quantiques s'accompagne d'une détérioration de ces dernières, ce qui nuit au rendement du dispositif. Enfin, la topographie induite par ce procédé de fabrication est très forte, ce qui limite la possibilité d'ajouter des filtres de couleur ou des lentilles.

Une deuxième approche décrite dans le document FR3101730 A1 prévoit de réaliser un ensemble d'ouvertures dans une couche d'oxyde, de les remplir de boîtes quantiques configurées pour convertir dans une première couleur, puis de répéter l'opération pour former des boîtes quantiques configurées pour convertir la lumière dans une deuxième couleur. Enfin, de nouvelles ouvertures sont formées entre les boîtes quantiques et une couche d'aluminium est déposée dans ces ouvertures pour isoler optiquement les boîtes quantiques. Cette deuxième approche nécessite un grand nombre d'étapes une fois les boîtes quantiques formées, ce qui conduit à leur dégradation et nuit au rendement du dispositif. Par ailleurs, l'alignement avec les diodes des ouvertures destinées à la formation des boîtes quantiques et des murs réfléchissants n'est pas aisé, notamment lorsque les écartements entre diodes sont faibles.

Une troisième approche décrite par exemple dans les documents US 2023/0033031 A1 et US 2023/0109233 A1 prévoit d'une part la formation d'un étage comprenant un ensemble de diodes et d'autre part la formation d'un étage comprenant un ensemble de boîtes quantiques séparées par des murs réfléchissants, puis le report des boîtes quantiques sur les diodes. Cette technologie nécessite donc un report, ce qui s'accompagne de problèmes liés à l'alignement et au collage. Par ailleurs, le cross-talk optique entre les diodes reste important.

Il existe donc un besoin d'un procédé de fabrication d'un dispositif optoélectronique intégrant des convertisseurs de couleurs résolvant au moins certains des problèmes soulevés ci-dessus. Notamment, le procédé selon l'invention s'affranchira de préférence de toute étape de report des convertisseurs de couleurs sur les diodes. Par ailleurs, le procédé selon l'invention permettra de préférence la formation des convertisseurs de couleurs en fin de procédé afin de limiter leur dégradation.

### RESUME

Pour atteindre cet objectif, selon un mode de réalisation on prévoit un procédé de fabrication d'un dispositif optoélectronique comprenant les étapes suivantes :
- fournir un empilement comprenant, empilés selon une direction dite transversale :
   - une couche active,
   - une couche isolante comprenant au moins une première sous-couche isolante à base d'un premier matériau électriquement isolant,
- former des ouvertures traversant la couche isolante et la couche active, de manière à définir dans la couche active une pluralité de diodes photoémettrices ou photoréceptrices, chaque diode étant surmontée d'une portion de la première sous-couche isolante, chaque ouverture s'étendant d'une part entre deux diodes voisines et d'autre part entre deux portions voisines de la première sous-couche isolante,
- au niveau de chaque ouverture, former une couche de revêtement électriquement isolante contre des flancs internes des diodes délimitant ladite ouverture,
- former dans chaque ouverture une couche réflectrice, la couche réflectrice s'étendant en partie au moins entre les deux portions voisines de la première sous-couche isolante entre lesquelles s'étend ladite ouverture,
- retirer au moins une des portions de la première sous-couche isolante, formant ainsi au moins une cavité, chaque cavité s'étendant entre deux couches réflectrices voisines et sur une diode de la pluralité de diodes,
- former un élément convertisseur dans l'au moins une cavité.

Les couches réflectrices formées dans les ouvertures forment des murs réfléchissants s'étendant a minima entre les éléments convertisseurs voisins, mais également de façon avantageuse entre les diodes voisines. Les couches réflectrices permettent donc de réduire le phénomène de cross-talk à la fois entre les diodes et entre les éléments convertisseurs, ce qui est un avantage important par rapport aux solutions de l'art antérieur dans lesquelles, du fait du procédé employé, les murs réfléchissants s'étendant entre les boîtes quantiques ne peuvent se prolonger entre les diodes (voir notamment les documents FR3061358, US 2023/0033031 A1, US 2023/0109233 A1). La réflexion de la lumière peut encore être améliorée en prévoyant un revêtement réflecteur (typiquement à base d'aluminium ou d'argent) entre la couche de revêtement électriquement isolante et la couche réflectrice. La couche réflectrice et le revêtement réflecteur peuvent notamment être utilisés en complément l'un de l'autre, par exemple pour assurer la réflexion de la lumière dans différentes plages de longueurs d'ondes. L'aluminium typiquement utilisé pour le revêtement réflecteur est par exemple un bon réflecteur pour les longueurs d'onde correspondant à une couleur bleue, et le cuivre typiquement utilisé pour les couches réflectrices est un bon réflecteur pour les longueurs d'onde correspondant à une couleur rouge.

Par ailleurs, le fait que chaque couche réflectrice puisse jouer le rôle de mur réfléchissant à la fois entre les diodes et entre les éléments convertisseurs permet de s'affranchir de toute discontinuité entre un miroir dédié aux diodes et un miroir dédié aux éléments convertisseurs. On évite ainsi toute fuite de lumière au niveau d'une telle discontinuité.

En outre, en réalisant cette couche réflectrice commune aux diodes et aux éléments convertisseurs lors d'une même étape de procédé, il est possible de dimensionner les diodes, les éléments convertisseurs ainsi que leur espacement selon les dimensions permises par les technologies de lithographie et de gravure, qui sont des dimensions très faibles. En effet, on s'affranchit des problèmes d'alignement entre la diode émettrice et la cavité accueillant le matériau convertisseur. On réduit ainsi l'empreinte surfacique consacrée à la réalisation des murs réfléchissants. La zone séparant deux diodes voisines et deux éléments réfléchisseurs voisins est en effet limitée au strict minimum : la couche de revêtement électriquement isolante et la couche réflectrice. On augmente ainsi le nombre de diodes pouvant être formées sur une même plaque et lors d'un même procédé.

Par ailleurs, en formant les ouvertures dans la couche isolante et dans la couche active, on réalise simultanément la singularisation des diodes au sein de la couche active et la définition des dimensions des futures cavités dans lesquelles seront ensuite formées les éléments convertisseurs. Cela permet non seulement de limiter le nombre d'étapes à réaliser, mais permet également un auto-alignement des cavités et donc des éléments convertisseurs avec les diodes sous-jacentes.

Les étapes de formation des couches réflectrices dans les ouvertures et de retrait de la première sous-couche isolante terminent de définir les cavités dans lesquelles les éléments convertisseurs peuvent ensuite facilement être formés. Il n'est donc pas nécessaire dans le procédé selon l'invention de fabriquer de façon séparée un étage comprenant les éléments convertisseurs puis de le reporter sur un étage comprenant les diodes, comme dans les documents US 2023/0033031 A1 et US 2023/0109233 A1 notamment. Le procédé permet de former les éléments convertisseurs directement au droit des diodes. L'invention permet donc de s'affranchir de toute étape de report et donc de tout problème d'alignement des éléments convertisseurs avec les diodes et de tout problème de collage.

En outre, dans le procédé selon la présente invention, les éléments convertisseurs sont formés en fin de procédé, notamment après la formation des couches réflectrices. Les éléments convertisseurs ne subissent notamment pas de retrait de matière au niveau de leur face supérieure comme cela était le cas dans le document FR3061358 A1. L'intégrité des éléments convertisseurs est donc bien préservée dans le procédé selon l'invention, ce qui permet d'améliorer le rendement du dispositif.

Le procédé selon la présente invention permet ainsi de résoudre les problèmes d'alignement entre les éléments convertisseurs et les diodes sous-jacentes. Il permet par ailleurs de limiter les pertes surfaciques. Le procédé fournit en outre une solution très efficace pour réduire voire supprimer les effets de cross-talk à la fois entre les diodes et entre les éléments convertisseurs.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1I illustrent un premier mode de réalisation du procédé selon l'invention.
Les figures 2A à 2L illustrent un deuxième mode de réalisation du procédé selon l'invention.
Les figures 3A à 3I illustrent un troisième mode de réalisation du procédé selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple avantageux, la couche isolante comprend en outre, empilés sur la première sous-couche isolante selon la direction transversale, une couche d'arrêt et une deuxième sous-couche isolante à base d'un deuxième matériau isolant, de préférence identique au premier matériau électriquement isolant, le procédé comprenant en outre une étape de retrait de la deuxième sous-couche isolante relativement à la couche d'arrêt. L'épaisseur de la première sous-couche isolante et de la couche d'arrêt définit ainsi la hauteur des murs. Ces couches servent ainsi à conférer aux murs la hauteur désirée, leur épaisseur pouvant être contrôlée avec grande précision grâce aux méthodes actuelles de dépôt. La deuxième sous-couche isolante sert quant à elle de protection lors de la formation des ouvertures dans la couche isolante.

De préférence, selon la direction transversale, la première sous-couche isolante présente une épaisseur e₂₁₀ supérieure ou égale à 500 nm, par exemple supérieure ou égale à 2 µm.

Selon un exemple préféré, au niveau de chaque ouverture, la formation de la couche de revêtement est configurée pour que la couche de revêtement s'étende en outre contre des flancs internes des deux portions voisines de la première sous-couche isolante entre lesquelles s'étend ladite ouverture, et, lors du retrait d'au moins une des portions de la première sous-couche isolante, des parties de la couche de revêtement s'étendent entre la couche réflectrice et les deux portions voisines de la première sous-couche isolante entre lesquelles s'étend la couche réflectrice sont conservées.

Selon un exemple, le procédé comprend en outre, au niveau de chaque ouverture, après l'étape de retrait d'au moins une des portions de la première sous-couche isolante et avant l'étape de formation de l'élément convertisseur dans l'au moins une cavité, une formation d'une première couche électriquement conductrice continue sur la diode sur laquelle se trouve ladite cavité et au contact d'au moins une des deux, de préférence des deux, couches réflectrices entre lesquelles s'étend la cavité.

Selon un exemple, la première couche électriquement conductrice s'étend de façon continue sur toutes les diodes et toutes les couches réflectrices.

Selon un exemple, l'empilement comprend en outre, entre la couche active et la couche isolante, une deuxième couche électriquement conductrice, les ouvertures traversant en outre la deuxième couche électriquement conductrice, et le procédé comprenant en outre, au niveau de chaque ouverture :
- avant la formation de la couche réflectrice, une formation d'une couche électriquement conductrice latérale contre des flancs internes des deux portions voisines de la première sous-couche isolante entre lesquelles s'étend ladite ouverture, la couche électriquement conductrice latérale étant en contact avec la deuxième couche électriquement conductrice,
- après la formation de la couche réflectrice, une formation d'une couche électriquement conductrice supérieure, en contact avec la couche électriquement conductrice latérale et avec la couche réflectrice formée dans ladite ouverture.

Selon un exemple, la formation de la couche électriquement conductrice supérieure est effectuée avant la formation de l'élément convertisseur.

Selon un exemple, la formation de la couche électriquement conductrice supérieure est effectuée après la formation de l'élément convertisseur et la couche électriquement conductrice supérieure s'étend sur l'élément convertisseur.

Selon un mode de réalisation, au niveau de chaque ouverture, la formation de la couche de revêtement est configurée pour que la couche de revêtement s'étende en outre contre des flancs internes des deux portions voisines de la première sous-couche isolante entre lesquelles s'étend ladite ouverture, le procédé comprenant en outre, après la formation dans chaque ouverture de la couche réflectrice, et de préférence simultanément au retrait d'au moins une des portions de la première sous-couche isolante, le retrait des parties de la couche de revêtement s'étendant entre la couche réflectrice et les deux portions voisines de la première sous-couche isolante entre lesquelles s'étend la couche réflectrice.

Selon un exemple, l'empilement comprend en outre, entre la couche active et la couche isolante, une deuxième couche électriquement conductrice, le procédé comprenant en outre, après le retrait desdites parties de la couche de revêtement, une formation d'une troisième couche électriquement conductrice en contact avec la couche réflectrice et avec la deuxième couche électriquement conductrice.

Selon un mode de réalisation le procédé comprend en outre, après la formation de la troisième couche électriquement conductrice, une formation d'une couche électriquement conductrice additionnelle contre une partie de la troisième couche électriquement conductrice étant au contact de la couche réflectrice et une formation d'un espaceur électriquement isolant contre la couche électriquement conductrice additionnelle.

Selon un exemple, la formation de l'élément convertisseur dans l'au moins une cavité comprend la formation d'au moins un premier élément convertisseur dans une première cavité et la formation d'au moins un deuxième élément convertisseur dans une deuxième cavité, le premier élément convertisseur étant configuré pour convertir une longueur d'onde native en une première longueur d'onde et le deuxième élément convertisseur étant configuré pour convertir la longueur d'onde native en une deuxième longueur d'onde distincte de la première longueur d'onde.

Selon un exemple, l'empilement comprend en outre, entre la couche active et la couche isolante, une deuxième couche électriquement conductrice s'étendant de façon continue entre la couche active et la couche isolante, et la formation des ouvertures comprend les étapes suivantes :
- gravure la couche isolante, avec arrêt sur la deuxième couche électriquement conductrice, puis
- graver la couche électriquement conductrice et la couche active.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

La présente demande de brevet peut aussi bien s'appliquer à une diode photoréceptrice qu'à une diode photoémettrice (ainsi qu'à des réseaux de telles diodes). Le terme « diode » s'entend donc indifféremment comme « diode photoréceptrice » ou « diode photoémettrice ». Dans la présente demande de brevet, les termes « diode photoémettrice », « diode électroluminescente » et « LED » sont employés en synonymes. Une « diode » peut également s'entendre d'une « micro-diode ». Une « micro-diode » est une diode dont les dimensions n'excèdent pas 1 mm (1 mm = 10⁻³ m), et typiquement pas 10µm (10 µm = 10⁻⁵ m).

Deux éléments sont dits « reliés électriquement » lorsqu'ils sont chacun en contact avec un même élément de connexion électrique continu présentant une conduction électrique de préférence supérieure ou égale à 2.10² S/m, de préférence supérieure ou égale à 2.10⁵ S/m. De préférence, la résistance carrée de l'élément de connexion électrique continu est supérieure ou égale à 50 Ω/□.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-N peut comprendre un matériau III-N additionné de dopants.

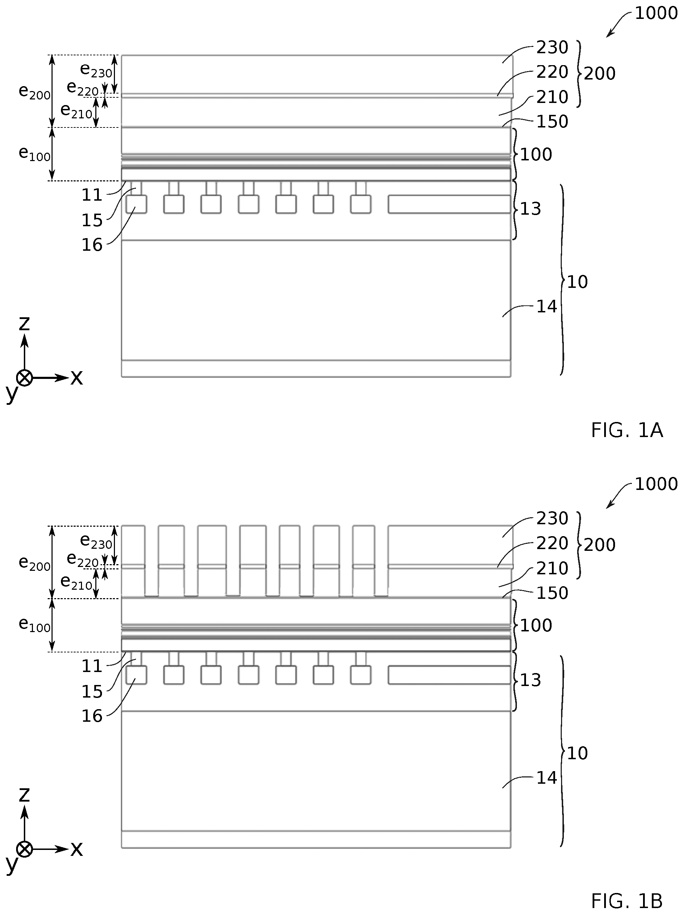

Un repère, de préférence orthonormé, comprenant les axes X, Y, Z est représenté en figures 1A, 2A et 3A. Ce repère est applicable par extension aux autres figures.

Dans la présente demande de brevet, on parlera préférentiellement d'épaisseur pour une couche et de hauteur pour une structure ou un dispositif. La hauteur est prise perpendiculairement au plan transversal XY. L'épaisseur est prise selon une direction normale au plan d'extension principal de la couche. Ainsi, une couche présente typiquement une épaisseur selon Z, lorsqu'elle s'étend principalement le long du plan transversal XY, et un élément en saillie, par exemple une tranchée, présente une hauteur selon Z. Les termes relatifs « sur », « sous », « sous-jacent » se réfèrent préférentiellement à des positions prises selon la direction Z.

Les termes « sensiblement », « environ », « de l'ordre de » signifient « à 10% près, de préférence à 5% près ».

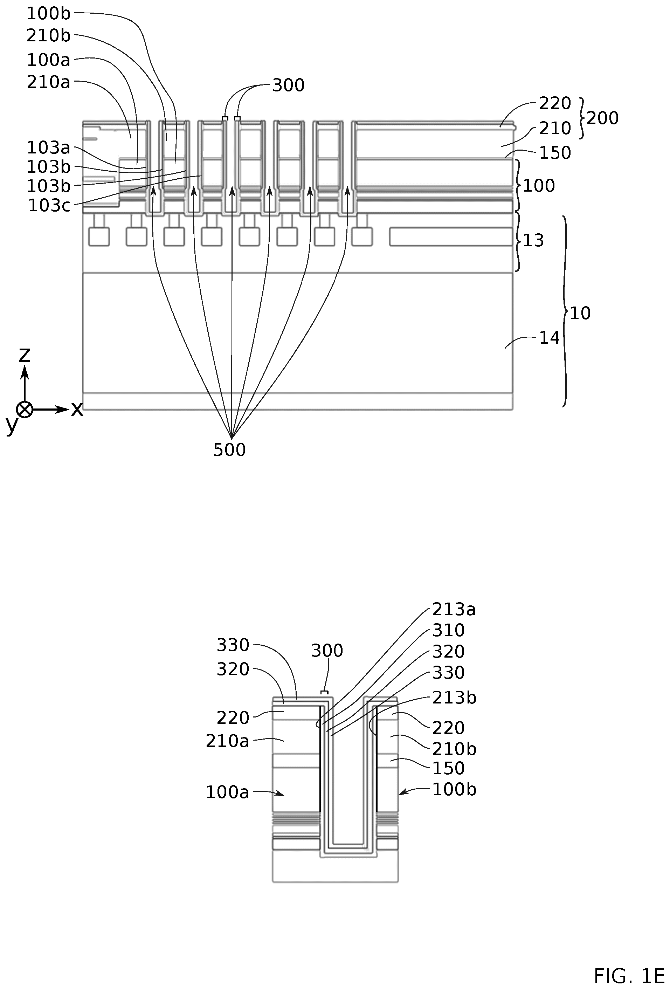

Le procédé selon la présente invention va maintenant être décrit en référence aux figures. De façon commune à tous les modes de réalisation, le procédé selon l'invention comprend au moins les étapes décrites ci-dessous. Certaines figures (figures 1E, 1F, 1G, 1H, 2C, 2D, 2E, 2F, 2G, 2I, 2J, 2K, 2L, 3B, 3C, 3D, 3E, 3F, 3G, 3H) comprennent un agrandissement sur une zone correspondant à deux diodes et l'ouverture puis la couche réflectrice les séparant, cela afin d'améliorer la visibilité des différentes couches déposées aux différentes étapes illustrées.

Tout d'abord, le procédé selon l'invention comprend la fourniture d'un empilement 1000 comprenant au moins, empilées l'une sur l'autre selon la direction transversale Z, une couche active 100 et une couche isolante 200 (figures 1A, 2A, 3A).

Ces couches 100, 200 reposent typiquement sur un substrat 10. Il s'agit typiquement d'un substrat 10 comprenant un circuit intégré, pouvant être désigné ASIC, de l'anglais « Application Specific Integrated Circuit » (en français « circuit intégré pour une application spécifique »).

Le substrat 10 présente une face supérieure 11 s'étendant principalement dans un plan parallèle au plan transversal XY.

Le substrat 10 peut par exemple comprendre une couche affleurante 13 et un substrat support 14. Le substrat support 14 peut par exemple être un substrat de silicium.

Le substrat 10, typiquement la couche affleurante 13, comprend de préférence une pluralité de vias métalliques 15 affleurant de préférence la face supérieure 11 du substrat 10. Chacun de ces vias métalliques 15 peut être en contact avec un plot métallique 16. Les vias métalliques 15 peuvent par exemple être à base de tungstène et les plots métalliques 16 peuvent par exemple être à base de cuivre ou d'aluminium.

La couche active 100 est typiquement ou comprend typiquement une couche photoémettrice ou photoréceptrice. Elle peut notamment comprendre les couches suivantes, empilées selon la direction d'empilement Z :
- une couche métallique, par exemple à base de titane, d'épaisseur par exemple inférieure ou égale à 2 µm, de préférence inférieure ou égale à 1 µm,
- un empilement type p-GaN/Al/TiTiN, d'épaisseur par exemple inférieure ou égale à 1 µm,
- une couche semiconductrice à base d'un matériau semiconducteur comprenant une région active pouvant être le lieu de recombinaisons radiatives de paires électron-trou permettant d'obtenir ou d'absorber un rayonnement lumineux. La région active comprend typiquement une pluralité de puits quantiques, par exemple formés par des couches à base de GaN, InN, InGaN, AlGaN, AIN, AlInGaN, GaP, AlGaP, AlInGaP, AlGaAs, GaAs, InGaAs, AlIIAs, ou d'une combinaison de plusieurs de ces matériaux. La région active peut par exemple s'étendre selon la direction d'empilement Z sur une épaisseur comprise entre 100 et 1000 nm. La couche semiconductrice dans sa totalité peut par exemple s'étendre selon la direction d'empilement Z sur une épaisseur comprise entre 1 µm et 2 µm.

La couche active 100 présente ainsi selon la direction d'empilement Z une épaisseur totale e₁₀₀ pouvant être comprise en 0,5 µm et 5 µm.

L'empilement 1000 peut par ailleurs comprendre une deuxième couche électrique conductrice 150 entre la couche active 100 et la couche isolante 200. La deuxième couche électriquement conductrice 150 s'étend de préférence de façon continue. Elle sépare de préférence entièrement la couche active 100 et la couche isolante 200. La couche isolante 200 présente selon la direction d'empilement Z une épaisseur e₂₀₀.

La couche isolante 200 comprend elle-même au moins une sous-couche isolante 210 à base d'un premier matériau électriquement isolant. Comme cela apparaîtra dans les différents modes de réalisation, la couche isolante 200 comprend typiquement en outre, sur la première sous-couche isolante 210, une couche d'arrêt 220 et une deuxième sous-couche isolante 230 à base d'un deuxième matériau isolant. La première sous-couche isolante 210, la couche d'arrêt 220 et la deuxième sous-couche isolante 230 présentent respectivement, selon la direction d'empilement Z une épaisseur e₂₁₀, e₂₂₀, e₂₃₀. e₂₁₀ peut être comprise en 100 nm et 10 µm. e₂₂₀ peut être sensiblement égale à 100 nm. e₂₃₀ peut être comprise en 100 nm et 3 µm. Comme cela apparaîtra plus avant, l'épaisseur de la première sous-couche isolante 210 conditionne la hauteur des cavités dans lesquelles sont formés les éléments convertisseurs. L'épaisseur e₂₁₀ est donc dimensionnée en fonction des dimensions typiques du type d'élément convertisseur choisi pour les applications visées.

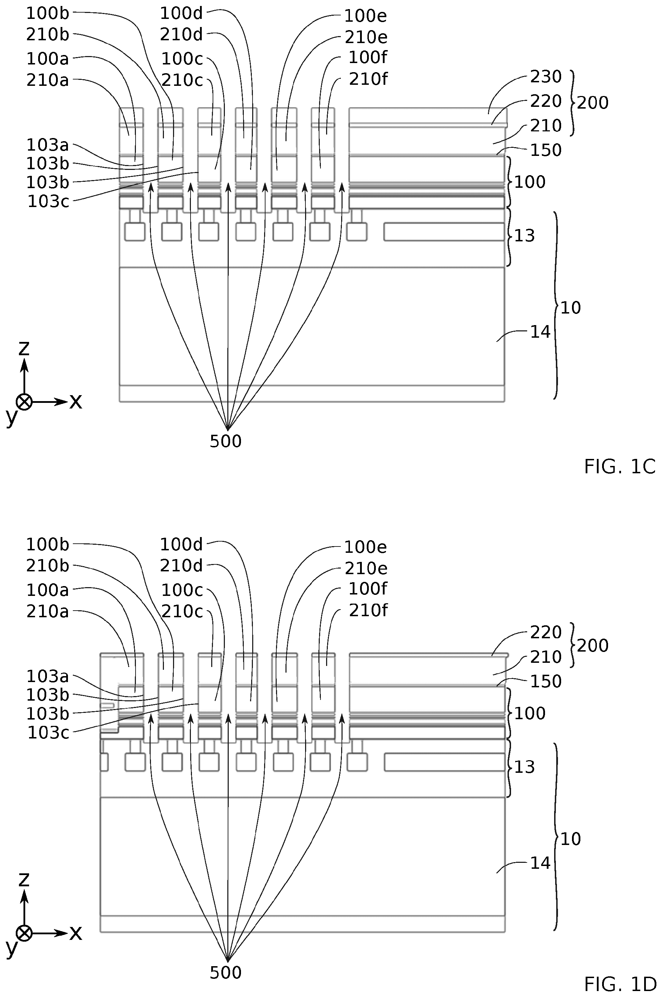

Le procédé selon l'invention prévoit ensuite la formation d'ouvertures 500 traversant la couche isolante 200 et la couche active 100 (figures 1C, 2D, 3C). La formation de ces ouvertures 500 permet de définir dans la couche active 100 une pluralité de diodes 100a, 100b, 100c. Ces diodes 100a, 100b, 100c peuvent être des diodes photoémettrices ou photoréceptrices, en fonction des applications visées. Cette étape peut être désignée étape de singularisation. Chaque diode 100a, 100b, 100c est typiquement en contact avec un via métallique 15.

Par construction, à l'issue de l'étape de formation des ouvertures 500, les diodes 100a, 100b, 100c formées dans la couche active 100 sont chacune surmontée d'une portion 210a, 210b, 210c de la première couche isolante 210. Par ailleurs, chaque ouverture 500 s'étend :
- d'une part entre deux diodes voisines, par exemple les diodes référencées 100a et 100b ou 100b et 100c sur les figures,
- d'autre part entre deux portions voisines de la première sous-couche isolante 210, par exemple les portions référencées 210a et 210b ou 210b et 210c sur les figures.

Ainsi, chaque ouverture 500 sépare, de préférence entièrement, les diodes voisines la bordant ainsi que les portions de la première sous-couche la bordant.

Au niveau des diodes 100a, 100b, 100c, les ouvertures 500 s'étendent plus précisément entre des flancs internes 103a, 103b, 103c des diodes 100a, 100b, 100c, formés lors de la formation des ouvertures 500. Ces flancs internes 103a, 103b, 103c délimitent ainsi les ouvertures 500 dans le plan transversal XY.

Le procédé selon l'invention prévoit par ailleurs la formation dans chaque ouverture 500 d'une couche de revêtement électriquement isolante 300 (également désignée couche de revêtement 300) (figures 1E, 2F, 3E). La couche de revêtement électriquement isolante 300 s'étend contre les flancs internes 103a, 103b, 103c des diodes 100a, 100b, 100c. Comme cela apparaîtra dans la suite de la description, la nature de la couche de revêtement 300 et notamment des sous-couches la formant pourront varier en fonction des modes de réalisation.

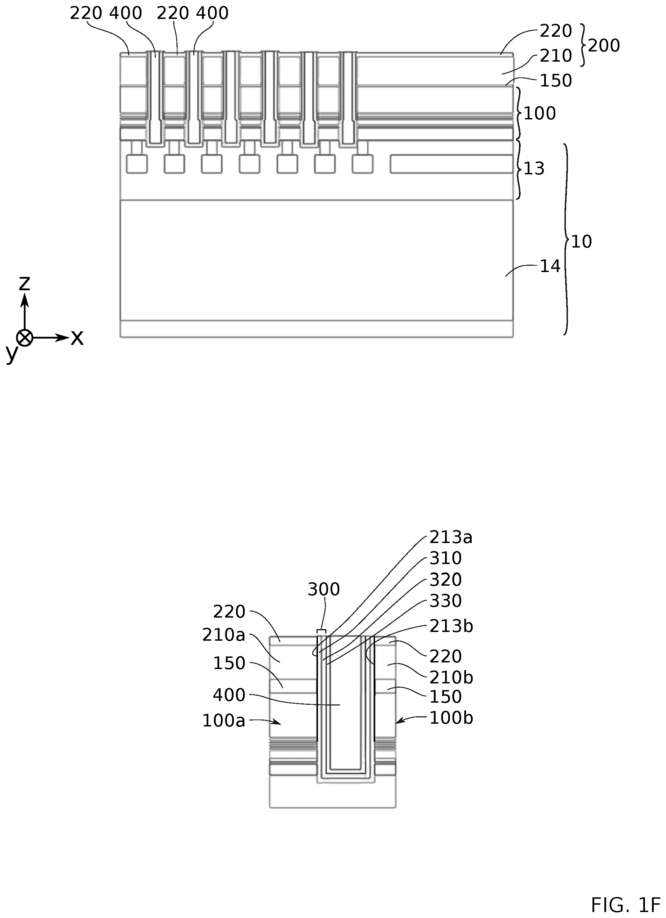

Le procédé selon l'invention prévoit ensuite la formation dans chaque ouverture 500 d'une couche réflectrice 400 (figures 1F, 2G, 3F). La couche réflectrice 400 est à base d'un matériau réfléchissant, pouvant également être un matériau électriquement conducteur, par exemple du cuivre. Elle s'étend au moins entre les deux portions voisines 210a, 210b ; 210b, 210c de la première sous-couche isolante 210 bordant l'ouverture 500 considérée. Elle s'étend par ailleurs contre la couche de revêtement électriquement isolante 300. La formation de la couche réflectrice 400 peut être réalisée par un remplissage de l'ouverture par le matériau réfléchissant, typiquement par dépôt électrochimique (couramment désigné ECD, de l'anglais « Electrochemical Deposition »).

La couche réflectrice 400 s'étend de préférence également entre les deux diodes voisines 100a, 100b ; 100b, 100c bordant l'ouverture 500 dans laquelle est formée la couche réflectrice 400. Dans tous les modes de réalisation, la couche réflectrice 400 a ainsi entre autres une fonction de réflexion de la lumière émise ou reçue pour limiter voire supprimer l'effet de cross-talk entre les diodes et entre les éléments convertisseurs qui seront formés lors d'une étape ultérieure.

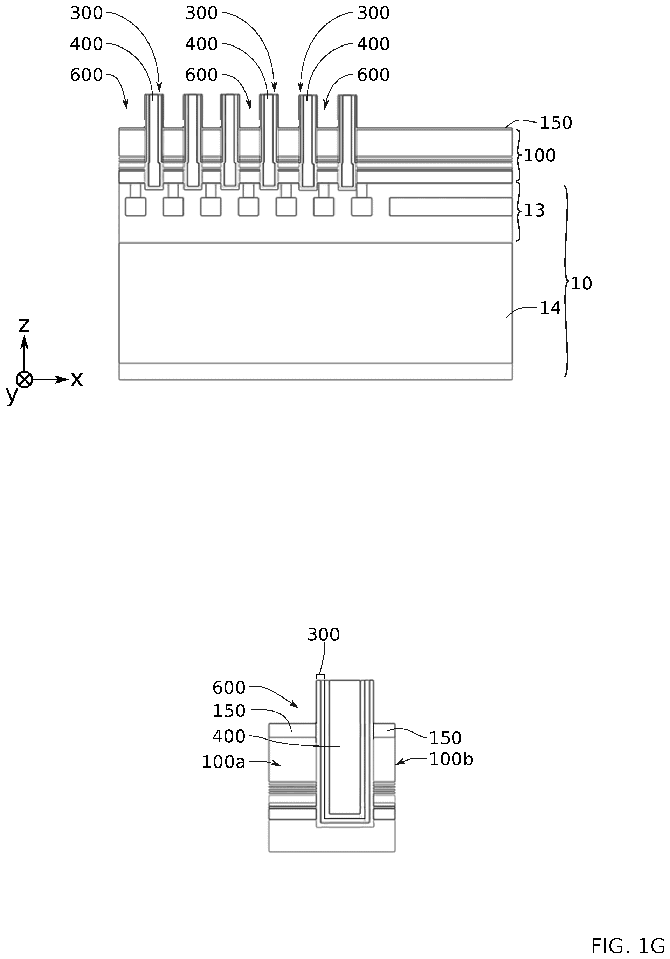

Le procédé selon l'invention prévoit ensuite de retirer au moins une des portions 210a, 210b, 210c de la première sous-couche isolante 210 (figures 1G, 2H, 3G). De préférence plusieurs de ces portions 210a, 210b, 210c voire toutes ces portions sont retirées. Ces portions 210a, 210b, 210c sont retirées sélectivement à la couche de revêtement 300 et à la couche réflectrice 400. En retirant ces portions 210a, 210b, 210c, on forme des cavités 600 s'étendant entre deux couches réflectrices 400 voisines. Par couches réflectrices 400 voisines, on entend des couches réflectrices 400 ayant été formées dans des ouvertures 500 voisines. Deux couches réflectrices 400 voisines bordent ainsi de part et d'autre une portion 210a, 210b, 210c de la première couche isolante 210, puis, si cette portion 210a, 210b, 210c est retirée, bordent de part et d'autre une cavité 600. Chaque cavité 600 s'étend par ailleurs sur une diode 100a, 100b, 100c. Autrement dit, chaque cavité 600 s'étend au droit d'une diode 100a, 100b, 100c selon la direction d'empilement Z. Les cavités 600 sont donc auto-alignées avec les diodes 100a, 100b, 100c par construction.

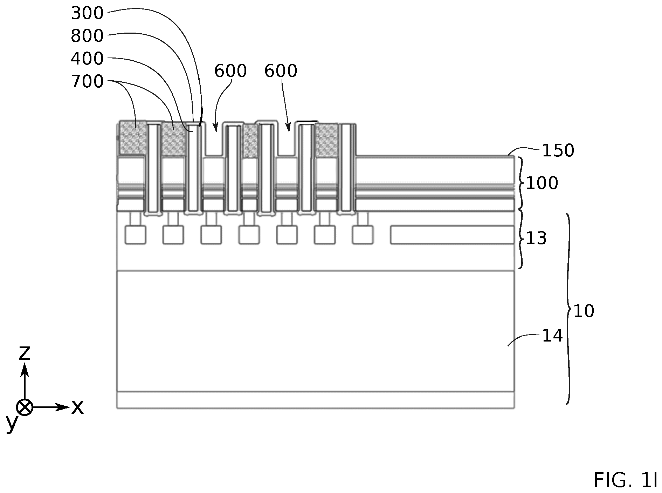

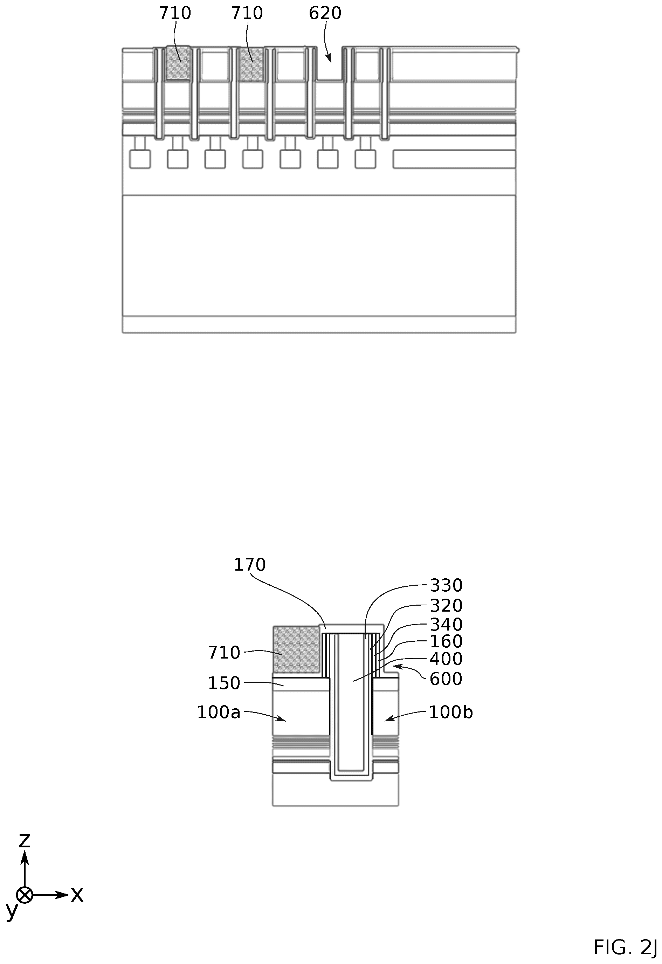

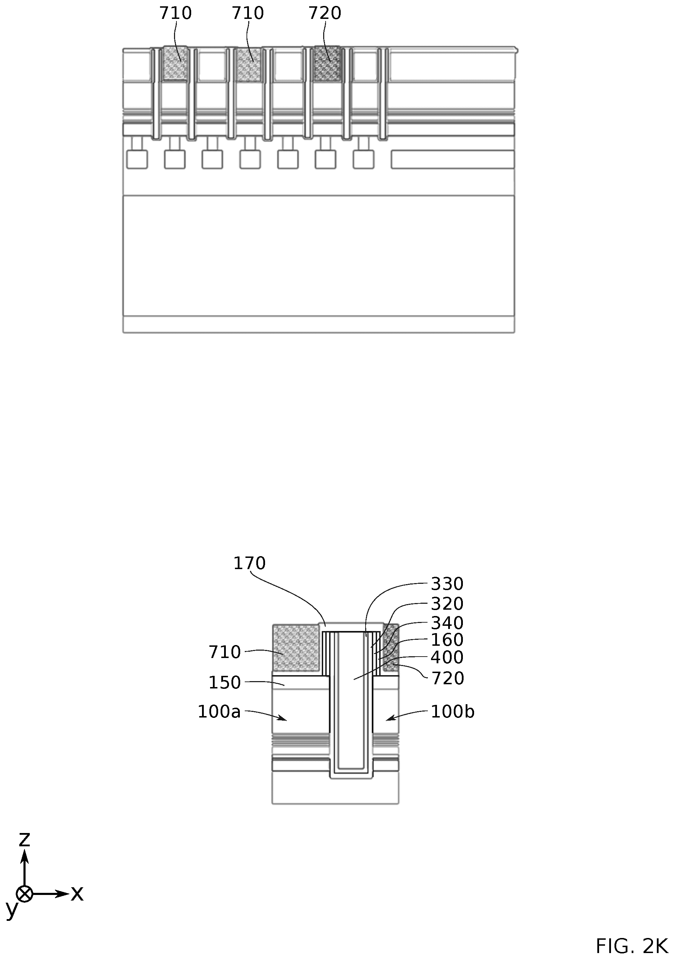

Le procédé selon l'invention prévoit enfin une étape de formation d'éléments convertisseurs 700 dans les cavités formées 700 (figures 1I, 2J, 2K). On entend par « élément convertisseur » un élément configuré pour convertir une longueur d'onde native en une longueur d'onde cible. Dans la présente invention, dans le cas où les diodes sont des diodes photoémettrices, la longueur d'onde native est typiquement la longueur d'onde émise par la diode 100a, 100b, 100c sous-jacente. La longueur d'onde cible est une longueur d'onde correspondant à une couleur d'émission désirée (par exemple rouge, vert ou bleu).

Les différents éléments convertisseurs 700 pourront être configurés pour convertir une longueur d'onde native en différentes longueurs d'onde cible. Par exemple, des premiers éléments convertisseurs 710 peuvent être configurés pour convertir la longueur d'onde native en une première longueur d'onde (par exemple appartenant à une plage de longueurs d'onde correspondant à du rouge) tandis que des deuxièmes éléments convertisseurs 720 peuvent être configurés pour convertir la longueur d'onde native en une deuxième longueur d'onde (par exemple appartenant à une plage de longueurs d'onde correspondant à du vert). Dans le cas de diodes 110a, 100b, 100c à base de GaN, la longueur d'onde native appartient typiquement à une plage de longueurs d'onde correspondant à du bleu.

Pour former au sein d'un même dispositif des éléments convertisseurs 710, 720 convertissant une longueur d'onde native en des longueurs d'onde distinctes, il est possible de mettre en œuvre les étapes suivantes :
- retrait de certaines portions de la première sous-couche 210 de manière à former des premières cavités 610, en conservant d'autres portions de la première sous-couche 210, typiquement par un masquage permis par des étapes classiques de photolithographie et gravure,
- former les premiers éléments convertisseurs 710 dans les premières cavités 610,
- ouvrir d'autres portions de la première sous-couche 210 de manière à former des deuxièmes cavités 620,
- former les deuxième éléments convertisseurs 720 dans les deuxièmes cavités 620.

Dans ce premier exemple, les portions de la première sous-couche 210 sont retirées au fur et à mesure que l'on forme différents ensembles d'éléments convertisseurs 710, 720.

Selon un autre exemple, il est possible de former différents éléments convertisseurs 710, 720 selon les étapes suivantes :
- retrait des portions de la première sous-couche 210 de manière à former les premières cavités 610 et les deuxièmes cavités 620,
- remplir les deuxièmes cavités 620 par un matériau de remplissage, typiquement une résine,
- former les premiers éléments convertisseurs 710 dans les premières cavités 610,
- retirer le matériau de remplissage des deuxièmes cavités, de manière à rouvrir les deuxièmes cavités 620,
- former les deuxième éléments convertisseurs 720 dans les deuxièmes cavités 620.

Dans ce deuxième exemple, on remplit temporairement les cavités dans lesquelles on ne souhaite pas former d'élément convertisseur.

Le principe de conserver certaines portions de la première sous-couche ou de remplir certaines cavités avec un matériau de remplissage peut également être utilisé pour tout simplement laisser certaines cavités dénuées d'éléments convertisseurs, par exemple si l'on souhaite que localement le dispositif émette/reçoive à la longueur d'onde native, via les diodes sous-jacentes.

Les éléments convertisseurs 700 sont typiquement des boîtes quantiques (« quantum dots » en anglais, souvent abrégé « QD »). On entend par boîte quantique une structure semi-conductrice capable de confiner des électrons (ou leurs lacunes) dans l'espace. Les boîtes quantiques sont typiquement à base de phosphure d'indium (InP) de préférence associé au séléniure de cadmium (CdSe) ou au sulfure de plomb (PbS).

Les éléments convertisseurs 700 peuvent également être à base de pérovskite ou de matériaux phosphorescents de type KSF (K₂SiF₆:Mn).

Plusieurs modes de réalisation vont maintenant être détaillés en référence aux figures d'accompagnement.

Un premier mode de réalisation du procédé selon l'invention est illustré aux figures 1A à 1I.

La figure 1A illustre la fourniture de l'empilement 1000 comprenant la couche active 100, la deuxième couche électriquement conductrice 150 et la couche isolante 200.

Comme illustré en figure 1B, on réalise ensuite une étape de gravure au travers de la couche isolante 200, avec arrêt sur la deuxième couche électriquement conductrice 150. Cette étape de gravure initie la formation des ouvertures 500.

La figure 1C illustre la finalisation des ouvertures 500 par gravure au travers de la deuxième couche électriquement conductrice 150 et de la couche active 100. A l'issue de cette étape, comme illustré sur la figure 1C, on obtient une pluralité de diodes 100a, 100b, 100c, 100d, 100e, 100f chacune surmontée par une portion de la couche isolante 200 et notamment par une portion 210a, 210b, 210c, 210d, 210e, 210f de la première sous-couche isolante 210.

On retire ensuite les portions de la deuxième sous-couche isolante 230 restantes (figure 1D). Ce retrait peut par exemple être effectué par polissage mécano-chimique (en anglais « Chemical mechanical poliching » ou CMP) avec arrêt sur la couche d'arrêt 220.

Comme illustré à la figure 1E, on procède ensuite à la formation de la couche de revêtement électriquement isolante 300 dans les ouvertures 500. Dans ce mode de réalisation, la couche de revêtement électriquement isolante 300 comprend de préférence au moins une première sous-couche de revêtement 310 au contact des flancs latéraux 213a, 213b des portions 210a, 210b de la première sous-couche isolante 210. Comme cela apparaîtra plus avant, la première sous-couche 310 pourra ainsi servir de couche d'arrêt lors du retrait des portions 210a, 210b de la première sous-couche isolante 210. Le matériau de la première sous-couche de revêtement 310 est ainsi choisi en fonction du matériau de la première sous-couche isolante 210. Il est de préférence choisi pour présenter une bonne sélectivité relativement au matériau de la première sous-couche isolante 210. Par exemple, lorsque le matériau de la première sous-couche isolante 210 est du SiO₂, la première sous-couche de revêtement 310 peut être à base de SiN.

La couche de revêtement électriquement isolante 300 peut également comprendre dans ce mode de réalisation une deuxième sous-couche 320 contre la première sous-couche 310. La deuxième sous-couche 320 peut par exemple être à base d'alumine (Al₂O₃). Un revêtement réflecteur 330 peut également être déposé contre la deuxième sous-couche 320. Le revêtement réflecteur 330 peut par exemple être à base d'aluminium ou d'argent. De préférence, les matériaux de la deuxième sous-couche de revêtement 320 et du revêtement réflecteur 330 sont également choisis pour présenter une bonne sélectivité relativement au matériau de la première sous-couche isolante 210.

Comme illustré à la figure 1F, on forme ensuite dans les ouvertures 500 la couche réflectrice 400.

Un polissage mécano-chimique peut ensuite être mis en œuvre afin de retirer les portions de la couche de revêtement 300 s'étendant sur les portions 210a, 210b, 210c de la première sous-couche isolante 210 et de mettre à niveau la couche réflectrice 400 avec la couche d'arrêt 220. Cette étape de CMP est facilitée par la présence de la couche d'arrêt 220, qui sert à arrêter le polissage. Cette étape peut être désignée étape de planarisation.

On retire ensuite certaines au moins des portions 210a, 210b, 210c de la première sous-couche isolante 210, ainsi que les portions de la couche d'arrêt 220 les surplombant, de manière à former les cavités 600 entre les couches réflectrices 400 (figure 1G).

Le retrait de la couche d'arrêt 220 et des portions 210a, 210b, 210c de la première sous-couche isolante 210 peut être effectué grâce à une gravure plasma, ciblant notamment la couche d'arrêt 220, puis une gravure du matériau de la première sous-couche isolante 210. Ces gravures se font sélectivement à la première sous-couche de revêtement 310 voire sélectivement à la couche de revêtement 300 dans son ensemble, ainsi qu'à la couche réflectrice 400.

Le retrait de la couche d'arrêt 220 et des portions 210a, 210b, 210c de la première sous-couche isolante 210 permet typiquement de mettre à jour la deuxième couche électriquement conductrice 150.

Dans ce mode de réalisation et à cette étape, les cavités 600 sont ainsi délimitées dans le plan transversal XY par la première sous-couche de revêtement 310. Autrement dit, dans ce mode de réalisation, après retrait de la deuxième sous-couche isolante 230, les portions des couches réflectrices 400 s'étendant au-delà de la couche d'arrêt 220 continuent d'être bordées par la couche de revêtement 300.

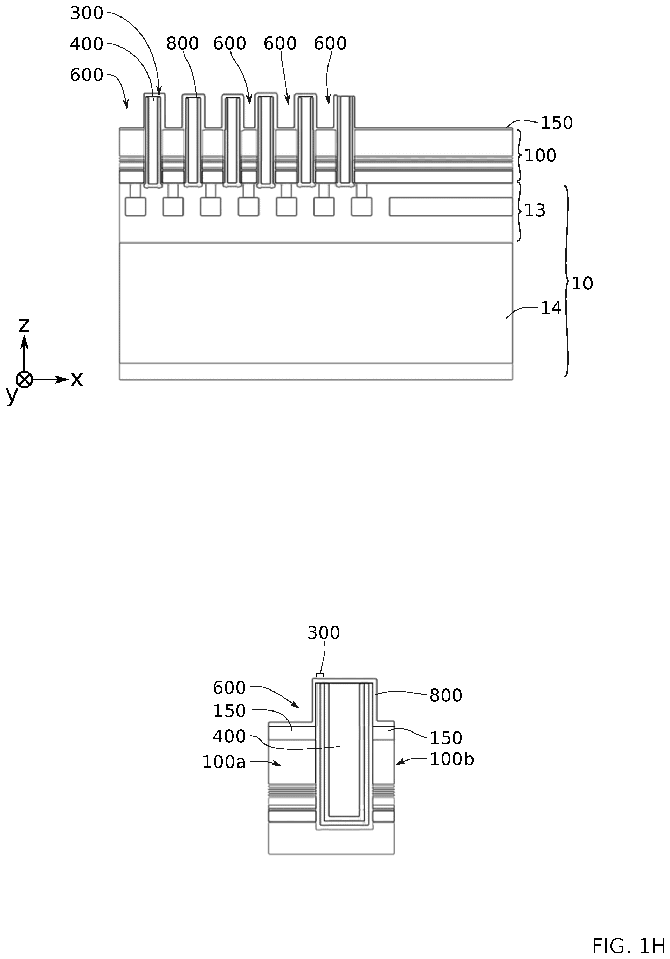

Comme illustré à la figure 1H, on forme ensuite une première couche électriquement conductrice 800 s'étendant sur les couches réflectrices 400 et sur la deuxième couche électriquement conductrice 150. La première couche électriquement conductrice 800 est de préférence déposée de façon conforme dans les cavités 600 et sur les couches de remplissage 400. La première couche électriquement conductrice 800 peut notamment être un film transparent conducteur (couramment désigné « TCO, de l'anglais « Transparent conductiveoxide »), par exemple à base d'oxyde d'indium-étain (ITO, de l'anglais « Indium tin oxide »), d'oxyde de zinc (ZnO), ou encore d'oxyde de zinc dopé gallium (GZO). Cela permet de ne pas entraver le passage de la lumière au-dessus des diodes 100a, 100b, 100c.

La première couche électriquement conductrice 800 a pour fonction de connecter électriquement les diodes 100a, 100b, 100c aux couches réflectrices 400 et plus généralement les diodes 100a, 100b, 100c entre elles.

En effet, avant la formation de la première couche électriquement conductrice 800, les diodes 100a, 100b, 100c sont isolées électriquement des couches réflectrices 400 par la couche de revêtement électriquement isolante 300. La première couche électriquement conductrice 800 permet donc de relier électriquement les diodes 100a, 100b, 100c entre elles.

Une fois la première couche électriquement conductrice 800 formée, les éléments convertisseurs 700 peuvent être formés dans les cavités 600 (figure 1I), selon les explications données plus haut de façon commune à tous les modes de réalisation.

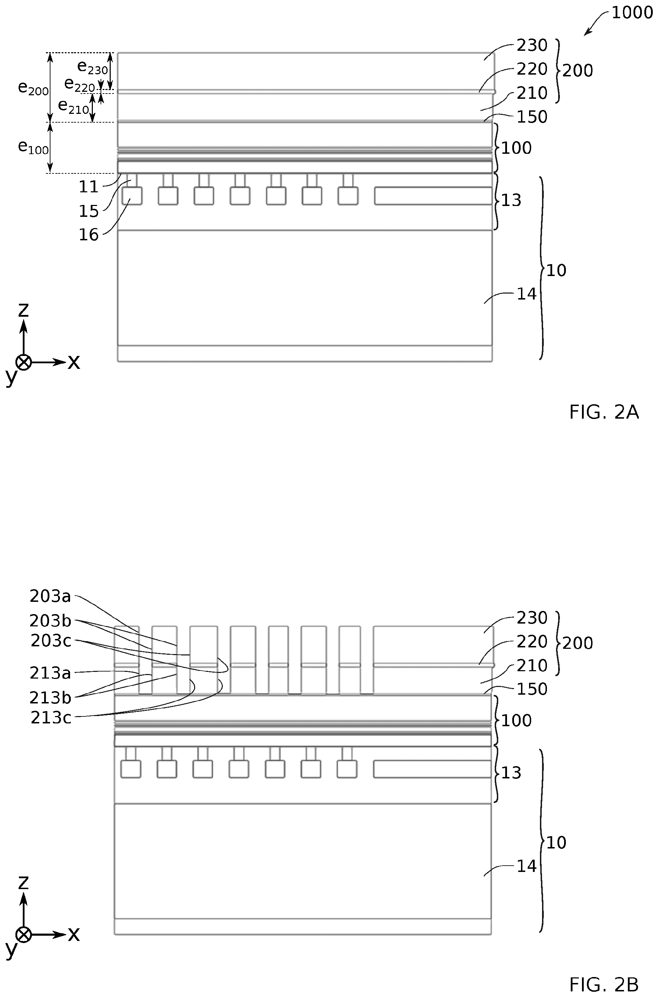

Un deuxième mode de réalisation du procédé selon l'invention est illustré aux figures 2A à 2L.

Le procédé selon le deuxième mode de réalisation débute de façon similaire au premier mode de réalisation avec la fourniture de l'empilement 1000 (figure 2A) et une gravure au travers de la couche isolante 200 avec arrêt sur la deuxième couche électriquement conductrice 150 (figure 2B).

La gravure au travers de la couche isolante 200 crée des flancs internes 203a, 203b, 203c dans la couche isolante 200. Les flancs internes 203a, 203b, 203c de la couche isolante 200 sont notamment en partie confondus avec des flancs internes 213a, 213b, 213c de la première sous-couche isolante 210.

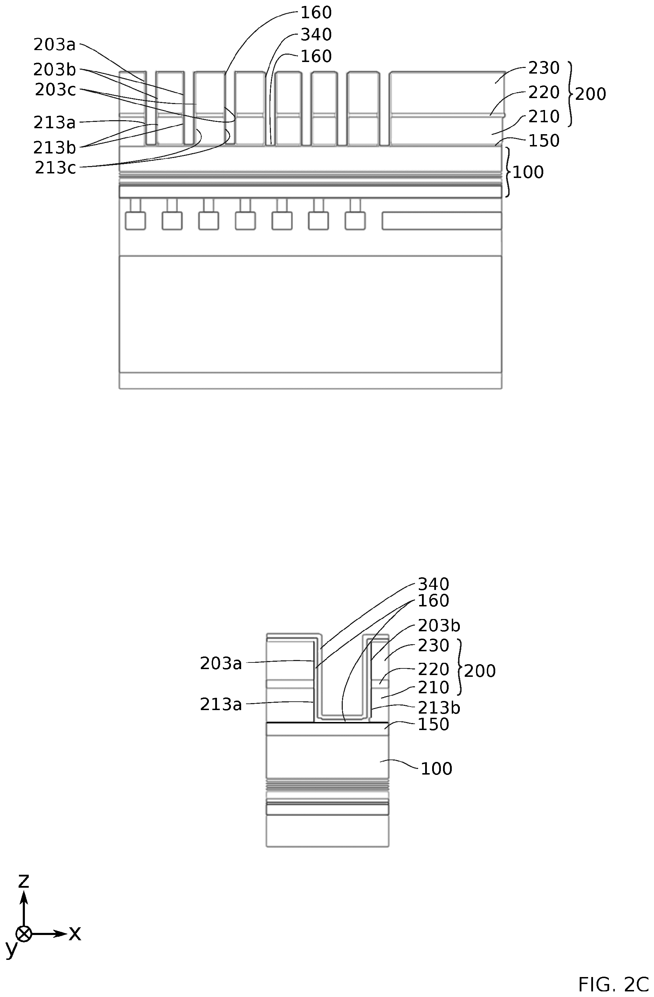

Dans le deuxième mode de réalisation, avant de poursuivre la gravure dans la couche active 100 pour finaliser les ouvertures 500, on forme une couche électriquement conductrice latérale 160 contre les flancs internes 203a, 203b, 203c de la couche isolante 200 formés à l'étape précédente. Cette étape est illustrée à la figure 2C. La couche électriquement conductrice latérale 160 recouvre ainsi notamment les flancs internes 213a, 213b, 213c de la première sous-couche isolante 210. La couche électriquement conductrice latérale 160 recouvre par ailleurs typiquement la deuxième couche électriquement conductrice 150 et s'étend par ailleurs sur la couche isolante 200. Le dépôt de la couche électriquement conductrice latérale 160 est de préférence réalisé de façon conforme. La couche électriquement conductrice latérale 160 peut par exemple présenter une épaisseur de 50nm. La couche électriquement conductrice latérale 160 peut notamment être un TCO, par exemple à base d'ITO ou de SnO₂.

De préférence, une quatrième sous-couche de revêtement 340 est déposée contre les flancs internes 203a, 203b, 203c dans la couche isolante 200, au contact de la couche électriquement conductrice latérale 160. La quatrième sous-couche de revêtement 340 peut notamment être à base d'Al₂O₃. La quatrième sous-couche de revêtement 340 peut être déposée de façon conforme et peut par exemple présenter une épaisseur de 50nm.

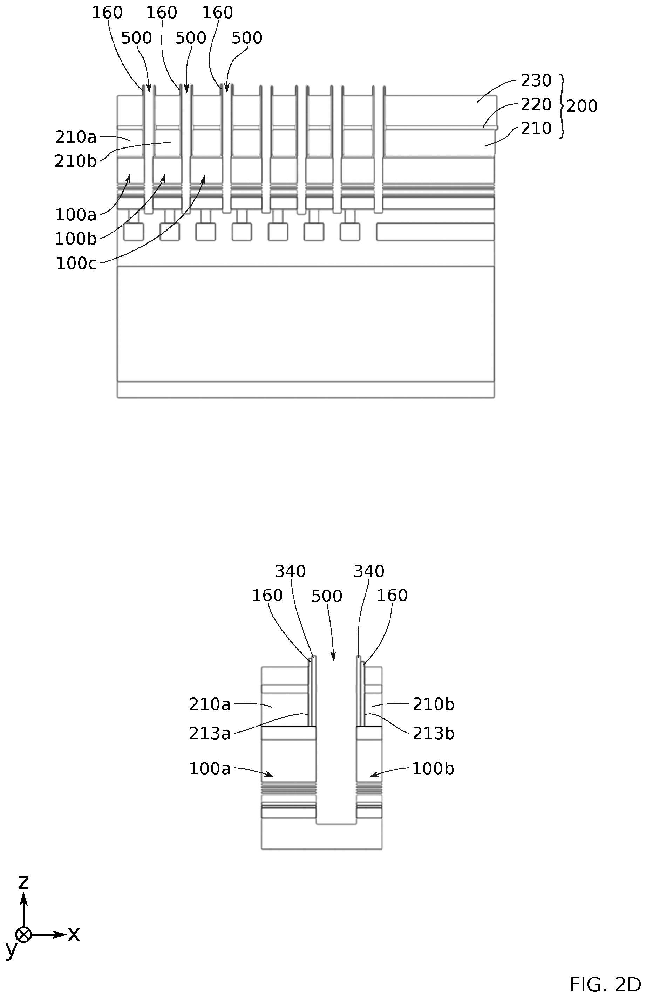

La figure 2D illustre la finalisation des ouvertures 500 par gravure au travers de la couche électriquement conductrice latérale 160, de la deuxième couche électriquement conductrice 150 et de la couche active 100. A l'issue de cette étape, comme illustré sur la figure 2D, on obtient une pluralité de diodes 100a, 100b, 100c, 100d, 100e, 100f chacune surmontée par une portion de la couche isolante 200 et notamment par une portion 210a, 210b, 210c, 210d, 210e, 210f de la première sous-couche isolante 210.

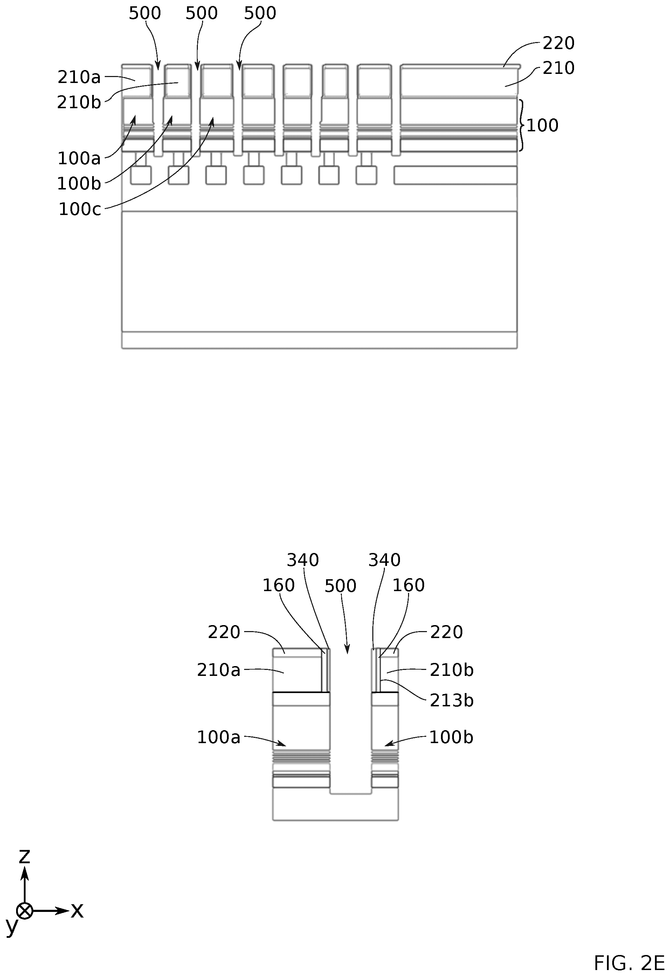

Comme dans le premier mode de réalisation, on retire ensuite les portions de la deuxième sous-couche isolante 230 restantes (figure 2E). Ce retrait peut par exemple être effectué par polissage mécano-chimique (en anglais « Chemical mechanical poliching » ou CMP) avec arrêt sur la couche d'arrêt 220.

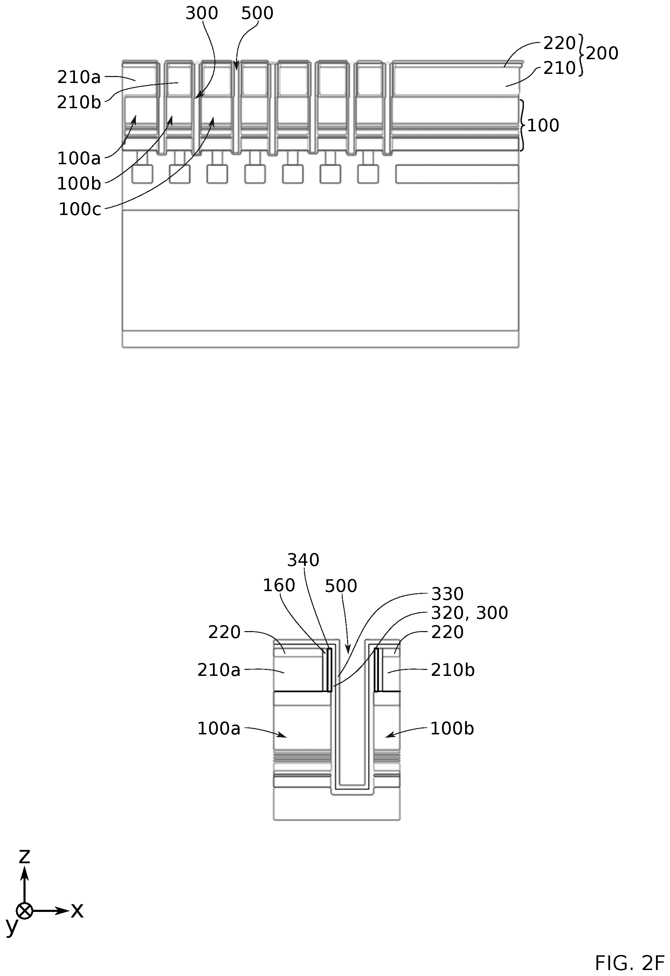

Comme illustré à la figure 2F, on procède ensuite à la formation de la couche de revêtement électriquement isolante 300 dans les ouvertures 500. La couche de revêtement électriquement isolante 300 peut par exemple comprendre une deuxième sous-couche 320 déposée contre les diodes 100a, 100b, 100c. La deuxième sous-couche 320 de la couche de revêtement 300 peut par exemple être à base d'alumine (Al₂O₃). Un revêtement réflecteur 330 peut également être déposé contre la deuxième sous-couche 320. Le revêtement réflecteur 330 peut par exemple être à base d'aluminium ou d'argent.

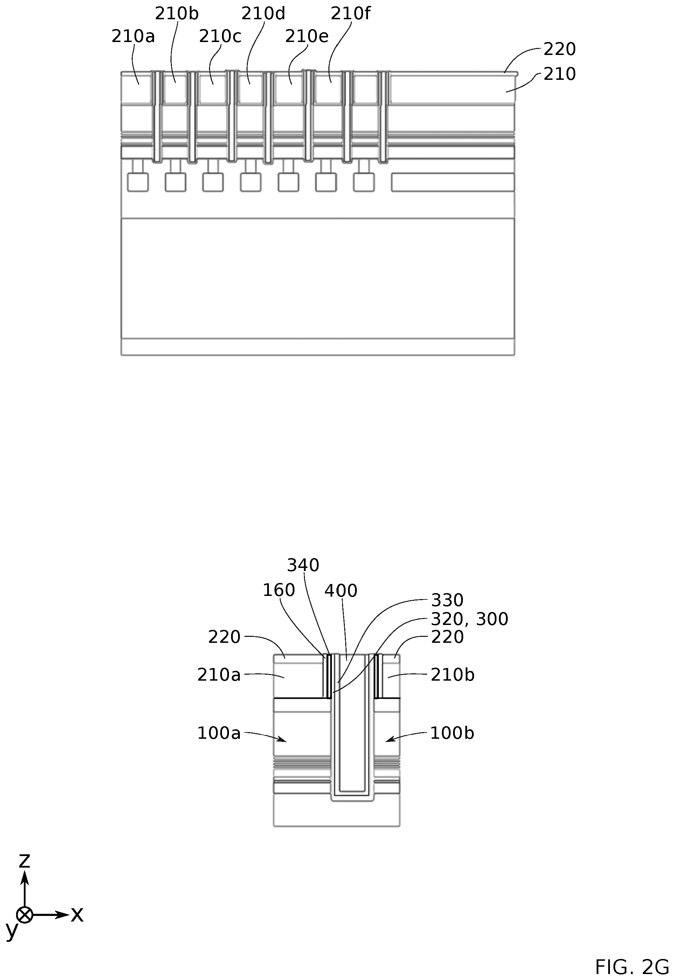

Comme illustré à la figure 2G, on forme ensuite dans les ouvertures 500 la couche réflectrice 400.

Comme dans le précédent mode de réalisation, un polissage mécano-chimique peut ensuite être mis en œuvre afin de retirer les portions de la couche de revêtement 300 s'étendant sur les portions 210a, 210b, 210c de la première sous-couche isolante 210 et de mettre à niveau la couche réflectrice 400 avec la couche d'arrêt 220. Cette étape de CMP est facilitée par la présence de la couche d'arrêt 220, qui sert à arrêter le polissage. Cette étape peut être désignée étape de planarisation.

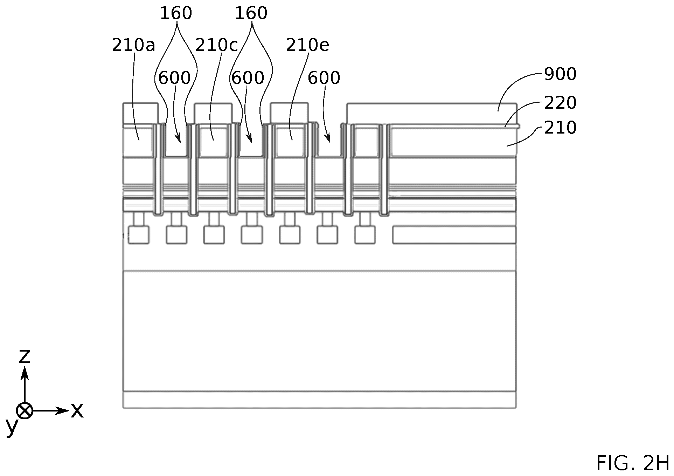

On retire ensuite certaines au moins des portions 210a, 210b, 210c de la première sous-couche isolante 210, ainsi que les portions de la couche d'arrêt 220 les surplombant, de manière à former les cavités 600 entre les couches réflectrices 400 (figure 2H). Sur la figure 2H, à titre d'exemple, seule certaines portions 210b, 210d, 210f de la première sous-couche isolante 210 ont été retirées tandis que d'autres 210a, 210c, 210e ont été conservées. Le retrait sélectif de certaines portions de la première sous-couche isolante 210 se fait typiquement par un procédé classique de photolithographie et gravure au travers d'une couche de résine photosensible 900 retirée ensuite.

Dans ce mode de réalisation et à cette étape, les cavités 600 sont ainsi délimitées dans le plan transversal XY par la couche électriquement conductrice latérale 160.

Par ailleurs, à cette étape, les diodes 100a, 100b, 100c sont isolées électriquement des couches réflectrices 400 puisqu'au niveau de chaque cavité 600, la couche de revêtement électriquement isolante 300 sépare la couche électriquement conductrice latérale 160 de la couche réflectrice 400. Il est donc nécessaire de réaliser une reprise de contact entre les diodes 100a, 100b, 100c et les couches réflectrices 400.

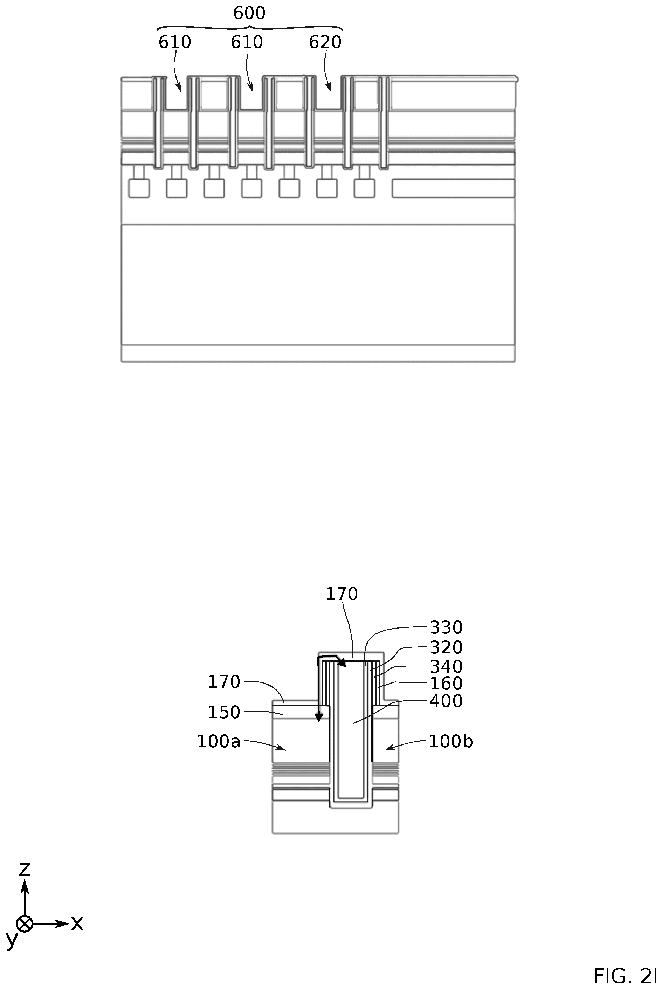

Les figures 2I à 2K illustrent une première option pour continuer le procédé selon le deuxième mode de réalisation tout en réalisant cette reprise de contact.

Dans cette première option, on forme ensuite une couche électriquement conductrice supérieure 170 permettant, au niveau de chaque cavité 600, une reprise de contact entre la couche électriquement conductrice latérale 160 et une couche réflectrice 400 voisine. La couche électriquement conductrice supérieure 170 est de préférence transparente. Cela permet de ne pas entraver le passage de la lumière au-dessus des diodes 100a, 100b, 100c. Typiquement, la couche électriquement conductrice supérieure 170 est déposée sur la deuxième couche électriquement conductrice 150, contre la couche électriquement conductrice latérale 160 et sur la couche réflectrice 400. La flèche représentée sur la figure 2I représente la reprise de contact électrique entre la diode 100a et la couche réflectrice 400 voisine permise par le dépôt de la couche électriquement conductrice supérieure 170.

Comme illustré aux figures 2J et 2K, on forme ensuite les éléments convertisseurs 700 souhaités dans les cavités 600 souhaitées. Par exemple, la figure 2J illustre la formation de premiers éléments convertisseurs 710 dans de premières cavités 610 et la figure 2K illustre la formation de deuxièmes éléments convertisseurs 720 dans de deuxièmes cavités 620.

Ainsi, dans ce premier exemple, la couche électriquement conductrice supérieure 170 est formée avant les éléments convertisseurs 700.

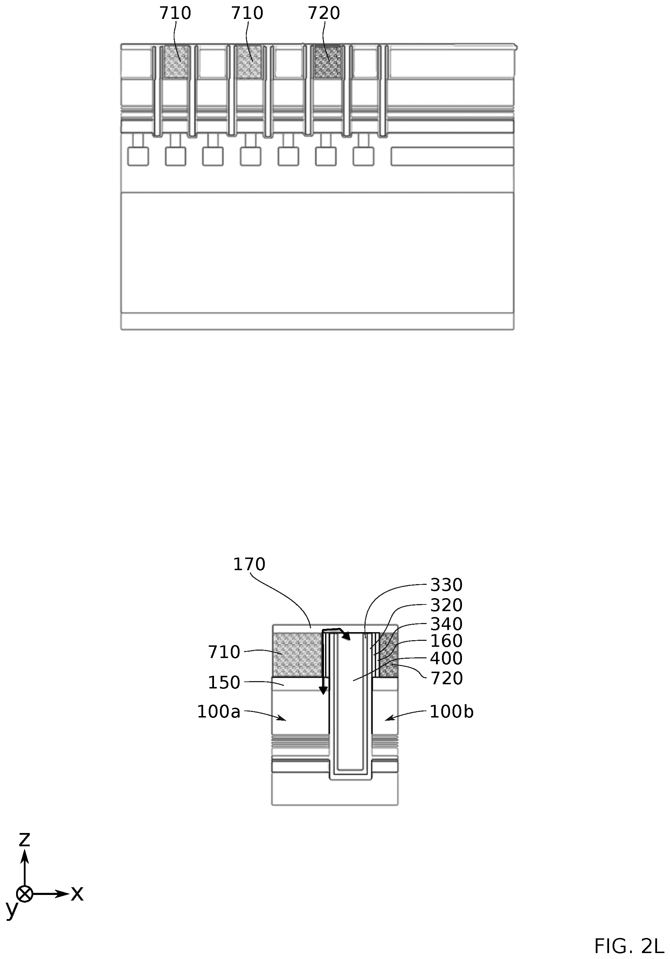

La figure 2L illustre une deuxième option pour continuer le procédé selon le deuxième mode de réalisation à la suite de la figure 2H tout en réalisant la reprise de contact entre les diodes 100a, 100b, 100c et les couches réflectrices 400.

Dans ce deuxième exemple, on commence par former les éléments convertisseurs 700, qui se trouvent ainsi directement au contact de la couche électriquement conductrice latérale 160. Ensuite, pour réaliser la reprise de contact, on dépose la couche électriquement conductrice supérieure 170 sur les éléments convertisseurs 700, la couche électriquement conductrice latérale 160 et la couche réflectrice 400.

Ainsi, dans ce deuxième exemple, la couche électriquement conductrice supérieure 170 est formée après les éléments convertisseurs 700.

La flèche représentée sur la figure 2L représente la reprise de contact électrique entre la diode 100a et la couche réflectrice 400 voisine permise par le dépôt de la couche électriquement conductrice supérieure 170.

Un avantage du deuxième mode de réalisation est que, du fait de la formation de la couche électriquement conductrice latérale 160, la remontée de contact électrique est réalisée en amont de la formation des cavités 600. La finalisation de la reprise de contact électrique entre les diodes 100a, 100b, 100c et les couches réflectrices 400 ne nécessite donc que le raccordement de la couche électriquement conductrice latérale 160, a minima par le haut, à la couche réflectrice 400 voisine. Il n'est donc pas nécessaire d'ouvrir toutes les cavités pour réaliser les reprises de contact avant de former les éléments convertisseurs. L'option illustrée à la figure 2L exploite tout particulièrement cet avantage puisque la reprise de contact électrique n'est finalisée qu'une fois les éléments convertisseurs formés, par simple dépôt de la couche électriquement conductrice supérieure 170 sur l'ensemble.

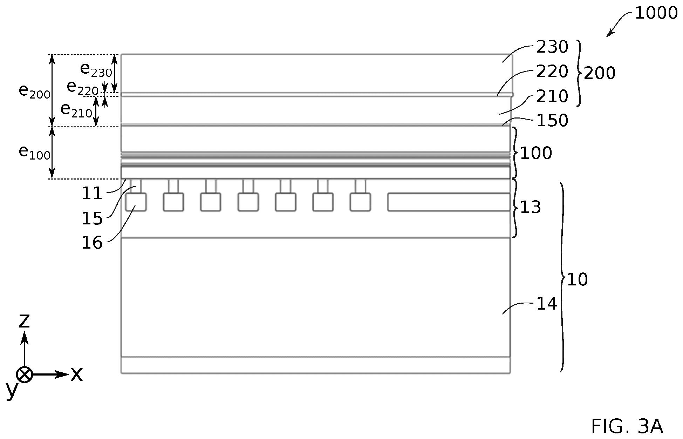

Un troisième mode de réalisation du procédé selon l'invention est illustré aux figures 3A à 3I.

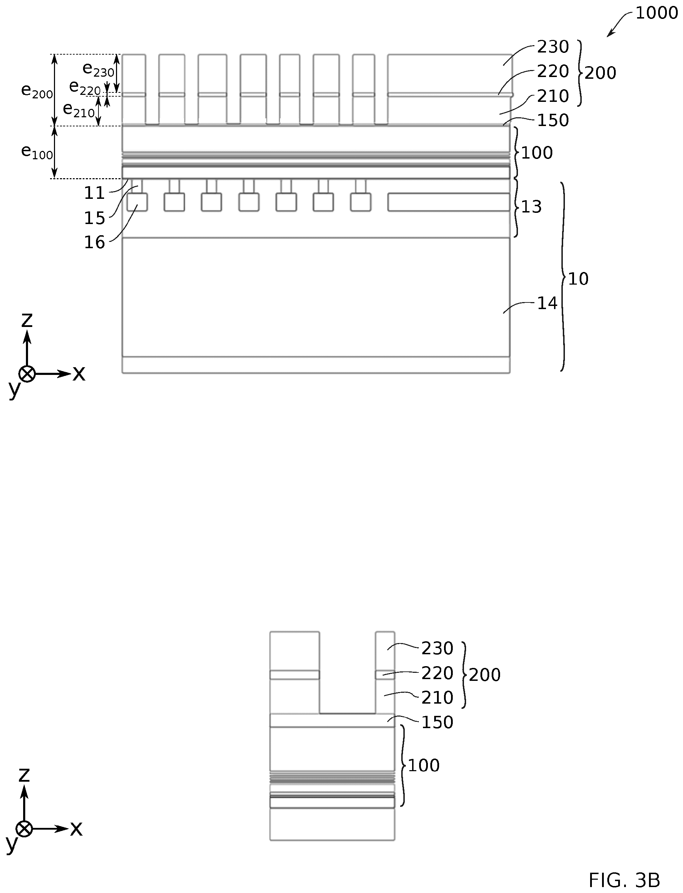

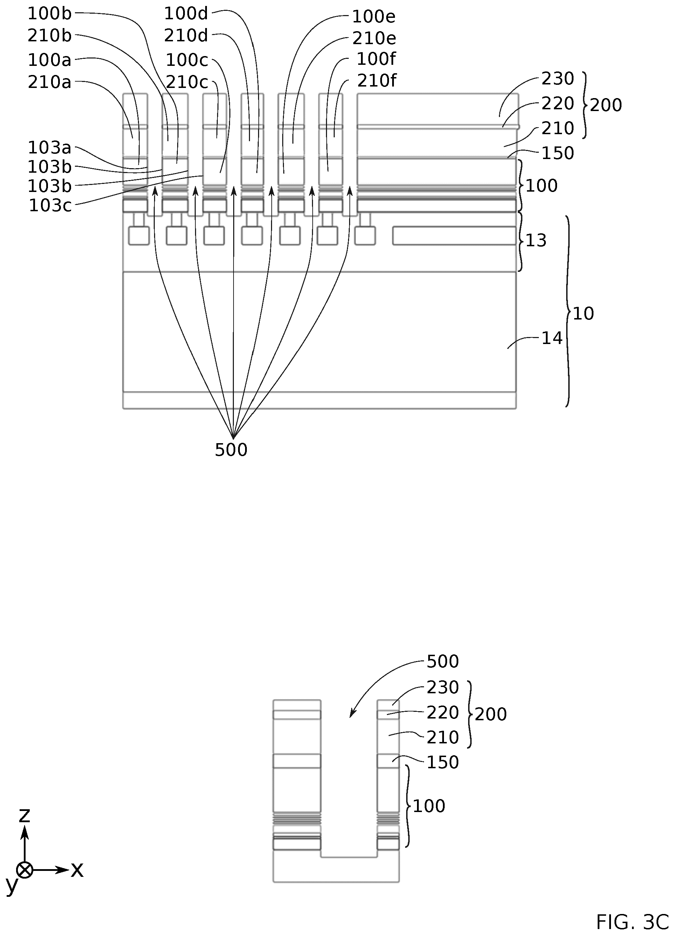

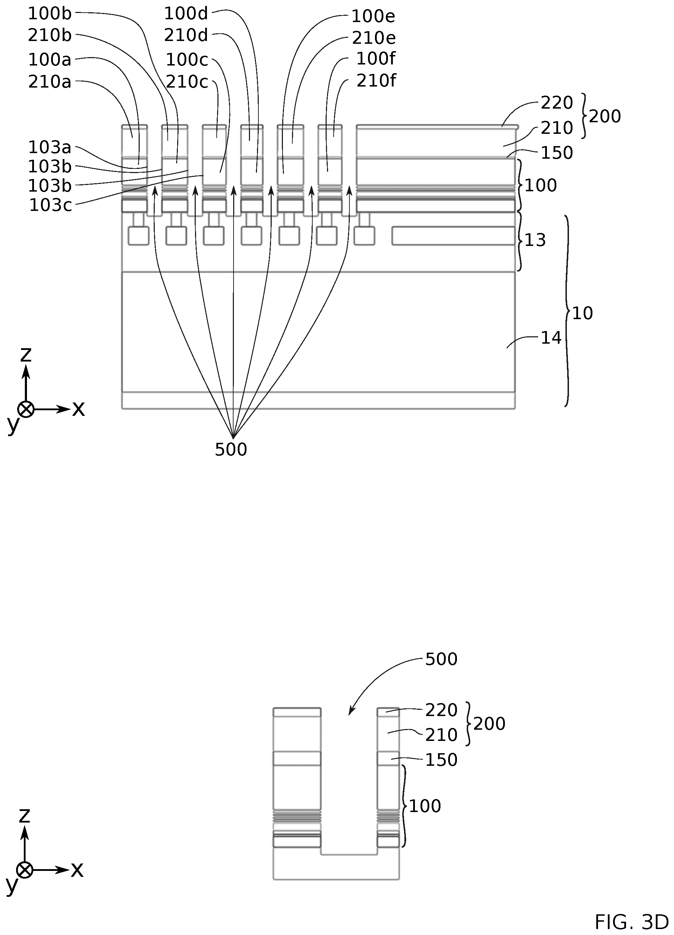

Le procédé selon le troisième mode de réalisation débute de façon similaire au premier mode de réalisation avec les étapes suivantes :
- la fourniture de l'empilement 1000 (figure 3A),
- la gravure au travers de la couche isolante 200 avec arrêt sur la deuxième couche électriquement conductrice 150 (figure 3B),
- la finalisation des ouvertures 500 par gravure dans la couche active 100 (figure 3C),
- le retrait des portions 210a, 210b, 210c de la première sous-couche isolante 210 (figure 3D).

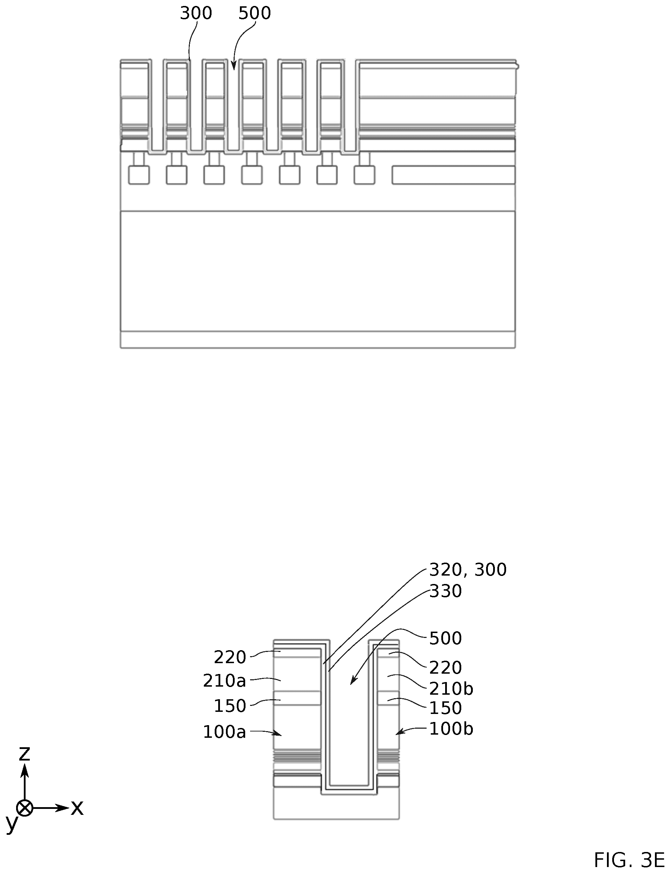

On forme ensuite la couche de revêtement électriquement isolante 300 dans les ouvertures 500 (figure 3E). Dans ce mode de réalisation, la couche de revêtement électriquement isolante 300 peut par exemple comprendre une deuxième sous-couche 320 déposée contre les diodes 100a, 100b, 100c. La deuxième sous-couche 320 de la couche de revêtement 300 peut par exemple être à base d'alumine (Al₂O₃). Un revêtement réflecteur 330 peut également être déposé contre la deuxième sous-couche 320. Le revêtement réflecteur 330 peut par exemple être à base d'aluminium ou d'argent.

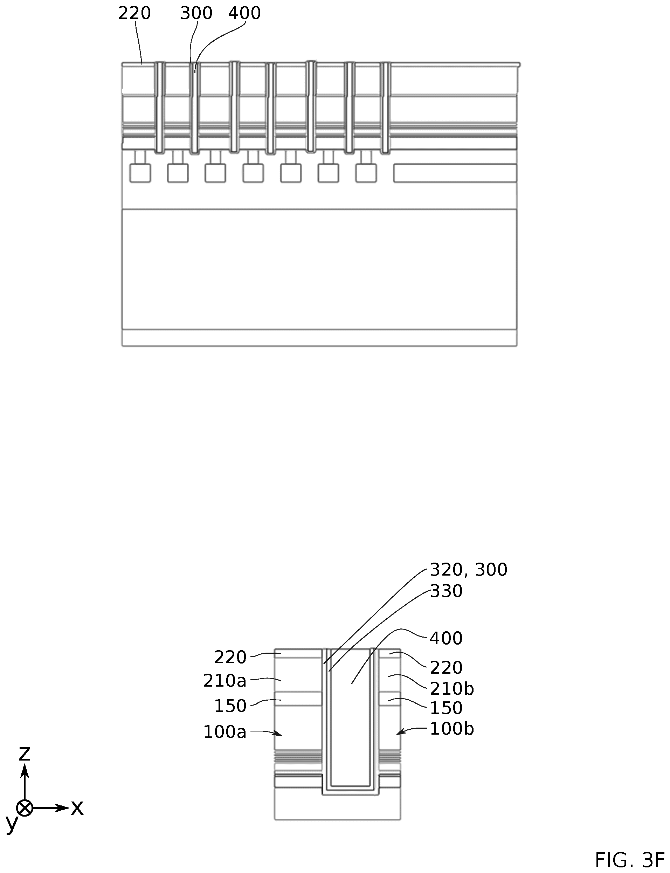

Comme dans les précédents modes de réalisation, on forme ensuite une couche réflectrice 400 dans chaque ouverture 500 (figure 3F).

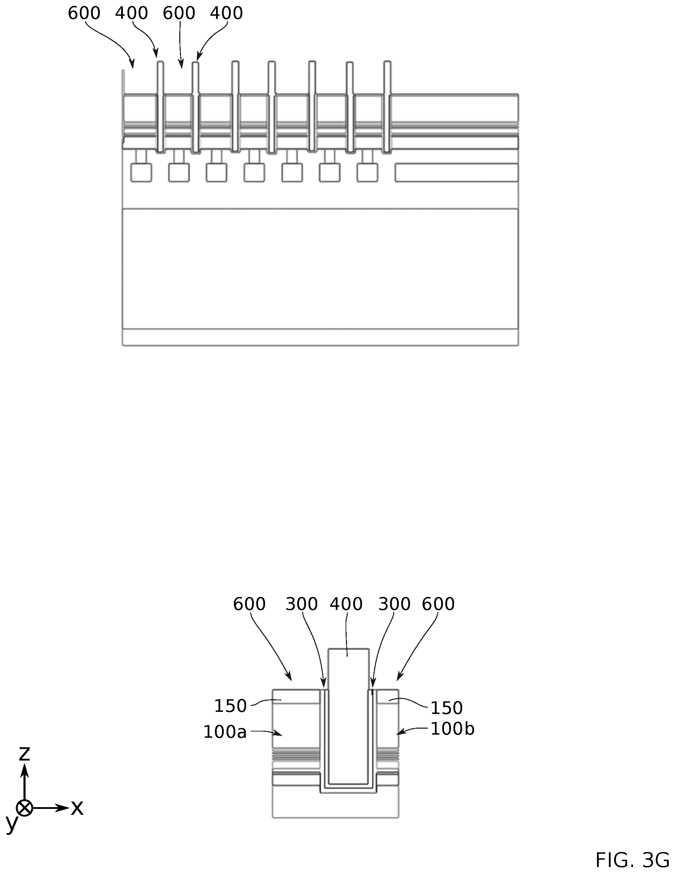

Comme dans les précédents modes de réalisation, on retire ensuite certaines au moins des portions 210a, 210b, 210c de la première sous-couche isolante 210, ainsi que les portions de la couche d'arrêt 220 les surplombant, de manière à former les cavités 600 entre les couches réflectrices 400 (figure 3G). Cependant, contrairement à ce qui était le cas dans les précédents modes de réalisation, on retire également les portions de la couche de revêtement 300 jouxtant les portions retirées de la première sous-couche 210. Autrement dit, on retire également les portions de la couche de revêtement 300 s'étendant au-delà de la deuxième couche électriquement conductrice 150 dans la direction d'empilement Z.

Le retrait des portions 210a, 210b, 210c de la première sous-couche isolante 210 et de la couche de revêtement 300 se fait typiquement par gravure sélective relativement aux couches réflectrices 400 et à la deuxième couche électriquement conductrice 150.

Dans ce mode de réalisation et à cette étape, les cavités 600 sont ainsi délimitées dans le plan transversal XY par les couches réflectrices 400.

Par ailleurs, à cette étape, les diodes 100a, 100b, 100c sont isolées électriquement des couches réflectrices 400 puisqu'au niveau de chaque cavité 600, la couche de revêtement électriquement isolante 300 sépare la deuxième couche électriquement conductrice 150 de la couche réflectrice 400. Il est donc nécessaire de réaliser une reprise de contact entre les diodes 100a, 100b, 100c et les couches réflectrices 400.

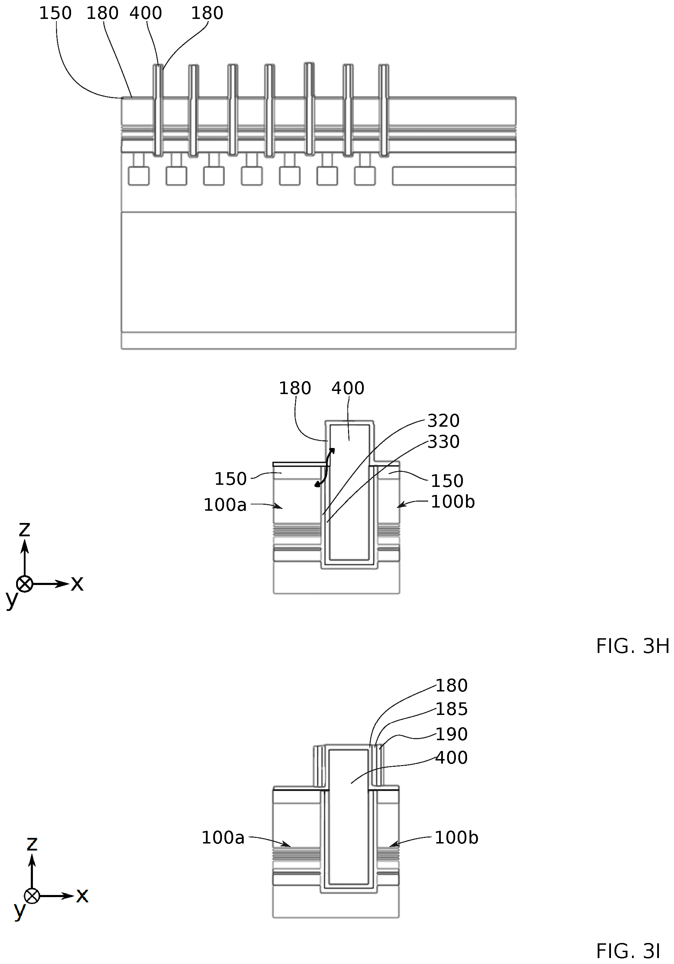

Pour cela, on forme ensuite une troisième couche électriquement conductrice 180 au contact de la deuxième couche électriquement conductrice 150 et des couches réflectrices 400 (figure 3H). La troisième couche électriquement conductrice 180 est typiquement un TCO, par exemple un ITO. Elle peut être formée par dépôt ou par bombardement. Un espaceur électriquement isolant 190 peut ensuite éventuellement être formé contre la troisième couche électriquement conductrice 180 (figure 3I). Une couche électriquement conductrice additionnelle 185, par exemple à base d'aluminium, est alors de préférence déposée avant l'espaceur 190 contre la troisième couche électriquement conductrice 180 afin d'assurer la réflexion lumineuse.

On prévoit enfin une étape de formation d'éléments convertisseurs 700 (non illustré) dans les cavités 600.

Ce troisième mode de réalisation présente l'avantage que la reprise de contact électrique entre une diode 100a, 100b, 100c et la couche réflectrice 400 voisine se fait, via la troisième couche électriquement conductrice, dès le ras de la portion de la couche réflectrice 400 s'étendant au-delà de la couche de revêtement 300, et non au niveau de la face supérieure de la couche réflectrice 400. Il n'y a donc pas de perte de potentiel due à la remontée de contact. La flèche représentée sur la figure 3H représente la reprise de contact électrique entre la diode 100a et la couche réflectrice 400 voisine dans cette zone plus basse que dans les modes de réalisation précédents. Ce troisième mode de réalisation est également simple à réaliser car il n'y a pas besoin de réaliser un dépôt conforme d'un film transparent conducteur car le contact électrique se fait dans le bas des cavités.

Au travers des différents modes de réalisation décrits ci-dessus, il apparaît que l'invention propose une solution efficace pour former des diodes et des convertisseurs de couleurs ainsi que des murs réfléchissants assurant l'isolation optique entre les diodes. Le procédé selon l'invention ne nécessite pas de report des éléments convertisseurs sur les diodes et en ce sens permet un auto-alignement entre les diodes et les éléments convertisseurs.

Le procédé selon l'invention peut être décliné selon différents modes de réalisation pour assurer la reprise de contact entre les diodes. Le choix du mode de réalisation pourra se faire en fonction des contraintes industrielles et des applications visées.

L'invention n'est pas limitée aux modes de réalisations précédemment décrits et s'étend à tous les modes de réalisation couverts par l'invention.

## Revendications

1. Procédé de fabrication d'un dispositif optoélectronique comprenant les étapes suivantes :
- fournir un empilement (1000) comprenant, empilés selon une direction dite transversale (Z) :
• une couche active (100),
• une couche isolante (200) comprenant au moins une première sous-couche isolante (210) à base d'un premier matériau électriquement isolant,
- former des ouvertures (500) traversant la couche isolante (200) et la couche active (100), de manière à définir dans la couche active (100) une pluralité de diodes (100a, 100b, 100c...) photoémettrices ou photoréceptrices, chaque diode (100a, 100b, 100c...) étant surmontée d'une portion (210a, 210b, 210c...) de la première sous-couche isolante (210), chaque ouverture (500) s'étendant d'une part entre deux diodes voisines (100a, 100b ; 100b, 100c...) et d'autre part entre deux portions voisines (210a, 210b ; 210b, 210c...) de la première sous-couche isolante (210),
- au niveau de chaque ouverture (500), former une couche de revêtement (300) électriquement isolante contre des flancs internes (103a, 103b ; 103b, 103c...) des diodes (100a, 100b ; 100b, 100c...) délimitant ladite ouverture (500),
- former dans chaque ouverture (500) une couche réflectrice (400), la couche réflectrice (400) s'étendant en partie au moins entre les deux portions voisines (210a, 210b ; 210b, 210c...) de la première sous-couche isolante (210) entre lesquelles s'étend ladite ouverture (500),
- retirer au moins une des portions (210a, 210b, 210c...) de la première sous-couche isolante (210), formant ainsi au moins une cavité (600), chaque cavité (600) s'étendant entre deux couches réflectrices (400) voisines et sur une diode de la pluralité de diodes (100a, 100b, 100c...),
- former un élément convertisseur (700) dans l'au moins une cavité (600).

2. Procédé selon la revendication précédente dans lequel la couche isolante (200) comprend en outre, empilés sur la première sous-couche isolante (210) selon la direction transversale (Z), une couche d'arrêt (220) et une deuxième sous-couche isolante (230) à base d'un deuxième matériau isolant, de préférence identique au premier matériau électriquement isolant, le procédé comprenant en outre une étape de retrait de la deuxième sous-couche isolante (230) relativement à la couche d'arrêt (220).

3. Procédé selon l'une quelconque des revendications précédentes dans lequel, selon la direction transversale (Z), la première sous-couche isolante (210) présente une épaisseur e₂₁₀ supérieure ou égale à 500 nm, par exemple supérieure ou égale à 2 µm.

4. Procédé selon l'une quelconque des revendications précédentes dans lequel, au niveau de chaque ouverture (500), la formation de la couche de revêtement (300) est configurée pour que la couche de revêtement (300) s'étende en outre contre des flancs internes (213a, 213b ; 213b, 213c...) des deux portions voisines (210a, 210b ; 210b, 210c...) de la première sous-couche isolante (210) entre lesquelles s'étend ladite ouverture (500), et dans lequel, lors du retrait d'au moins une des portions (210a, 210b, 210c...) de la première sous-couche isolante (210), des parties de la couche de revêtement (300) s'étendant entre la couche réflectrice (400) et les deux portions voisines (210a, 210b ; 210b, 210c...) de la première sous-couche isolante (210) entre lesquelles s'étend la couche réflectrice (400) sont conservées.

5. Procédé selon la revendication précédente comprenant en outre, au niveau de chaque ouverture (500), après l'étape de retrait d'au moins une des portions (210a, 210b, 210c...) de la première sous-couche isolante (210) et avant l'étape de formation de l'élément convertisseur (700) dans l'au moins une cavité (600), une formation d'une première couche électriquement conductrice continue (800) sur la diode (100a, 100b, 100c...) sur laquelle se trouve ladite cavité (600) et au contact d'au moins une des deux, de préférence des deux, couches réflectrices (400) entre lesquelles s'étend la cavité (600).

6. Procédé selon la revendication précédente dans lequel la première couche électriquement conductrice (800) s'étend de façon continue sur toutes les diodes (100a, 100b, 100c...) et toutes les couches réflectrices (400).

7. Procédé selon la revendication 4 dans lequel l'empilement (1000) comprend en outre, entre la couche active (100) et la couche isolante (200), une deuxième couche électriquement conductrice (150), dans lequel les ouvertures (500) traversent en outre la deuxième couche électriquement conductrice (150), le procédé comprenant en outre, au niveau de chaque ouverture (500) :
- avant la formation de la couche réflectrice (400), une formation d'une couche électriquement conductrice latérale (160) contre des flancs internes (213a, 213b, 213c) des deux portions voisines (210a, 210b ; 210b, 210c...) de la première sous-couche isolante (210) entre lesquelles s'étend ladite ouverture (500), la couche électriquement conductrice latérale (160) étant en contact avec la deuxième couche électriquement conductrice (150),
- après la formation de la couche réflectrice (400), une formation d'une couche électriquement conductrice supérieure (170), en contact avec la couche électriquement conductrice latérale (160) et avec la couche réflectrice (400) formée dans ladite ouverture (500).

8. Procédé selon l'une quelconque des deux revendications précédentes dans lequel la formation de la couche électriquement conductrice supérieure (170) est effectuée avant la formation de l'élément convertisseur (700).

9. Procédé selon la revendication 7 dans lequel la formation de la couche électriquement conductrice supérieure (170) est effectuée après la formation de l'élément convertisseur (700) et dans lequel la couche électriquement conductrice supérieure (170) s'étend sur l'élément convertisseur (700).

10. Procédé selon l'une quelconque des revendications 1 à 6 dans lequel, au niveau de chaque ouverture (500), la formation de la couche de revêtement (300) est configurée pour que la couche de revêtement (300) s'étende en outre contre des flancs internes des deux portions voisines de la première sous-couche isolante (210) entre lesquelles s'étend ladite ouverture (500), le procédé comprenant en outre, après la formation dans chaque ouverture (500) de la couche réflectrice (400), et de préférence simultanément au retrait d'au moins une des portions de la première sous-couche isolante (210), le retrait des parties de la couche de revêtement (300) s'étendant entre la couche réflectrice (400) et les deux portions voisines de la première sous-couche isolante (210) entre lesquelles s'étend la couche réflectrice (400).

11. Procédé selon la revendication précédente dans lequel l'empilement (1000) comprend en outre, entre la couche active (100) et la couche isolante (200), une deuxième couche électriquement conductrice (150), le procédé comprenant en outre, après le retrait desdites parties de la couche de revêtement, une formation d'une troisième couche électriquement conductrice (180) en contact avec la couche réflectrice (400) et avec la deuxième couche électriquement conductrice (150).

12. Procédé selon la revendication précédente comprenant en outre, après la formation de la troisième couche électriquement conductrice (180), une formation d'une couche électriquement conductrice additionnelle (185) contre une partie de la troisième couche électriquement conductrice (180) étant au contact de la couche réflectrice (400) et une formation d'un espaceur électriquement isolant (190) contre la couche électriquement conductrice additionnelle (185).

13. Procédé selon l'une quelconque des revendications précédentes dans lequel la formation de l'élément convertisseur (700) dans l'au moins une cavité (600) comprend la formation d'au moins un premier élément convertisseur (710) dans une première cavité (610) et la formation d'au moins un deuxième élément convertisseur (720) dans une deuxième cavité (620), le premier élément convertisseur (710) étant configuré pour convertir une longueur d'onde native en une première longueur d'onde et le deuxième élément convertisseur (720) étant configuré pour convertir la longueur d'onde native en une deuxième longueur d'onde distincte de la première longueur d'onde.

14. Procédé selon l'une quelconque des revendications précédentes dans lequel l'empilement (1000) comprend en outre, entre la couche active (100) et la couche isolante (200), une deuxième couche électriquement conductrice (150) s'étendant de façon continue entre la couche active (100) et la couche isolante (200), et dans lequel la formation des ouvertures (500) comprend les étapes suivantes :
- gravure la couche isolante (200), avec arrêt sur la deuxième couche électriquement conductrice (150), puis
- graver la couche électriquement conductrice (150) et la couche active (100).
